# EUROPEAN PATENT APPLICATION

(11) **EP 2 410 017 A1**
(43) Date of publication of application: **25.01.2012**
(21) Application number: 10753592.4
(22) Date of filing: 15.03.2010
(51) Int. Cl.: C08L 65/00, C08G 61/12, C08K 3/04, C09D 5/24, C09D 11/00, C09K 11/06, G01J 1/02, H01L 51/42

(54) **COMPOSITION AND ELEMENT USING SAME**

(30) Priority: 17.03.2009 JP 2009063977
(71) Applicant: Sumitomo Chemical Company, Limited, Tokyo 104-8260 (JP)
(72) Inventor: YOSHIMURA, Ken, Tsukuba-shi Ibaraki 305-0821 (JP); KATO, Takehito, Oyama-shi Tochigi 323-0811 (JP)
(74) Representative: Vossius & Partner
(86) International application number: PCT/JP2010/054736
(87) International publication number: WO 2010/107101

(57) **Abstract**

A composition comprising a first compound having a structure represented by formula (1), and a second compound composed of only a structure different from the structure represented by formula (1).

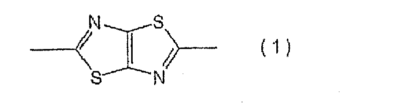

## Description

### TECHNICAL FIELD

The present invention relates to a specific composition, and a device using the same.

### BACKGROUND ART

In order to prevent global warming, there has recently been required to reduce CO₂ emitted into the atmosphere. Therefore, for example, there is made a proposal of employment of a solar system using a p-n junction silicon-based solar battery or the like. However, high temperature and high vacuum conditions are required in the production process of single crystal, polycrystal and amorphous silicon as materials of the silicon-based solar battery.

On the other hand, an organic thin film solar battery such as an organic solar battery would be able to be produced at a low price by only an applying process without a high temperature or high vacuum process, and thus it has attracted special interest recently. For example, there is known an organic solar battery containing a composition of a copolymer composed of a repeating unit (A) and a repeating unit (B), and a phenyl C61-butyric acid methyl ester (C60PCBM) (Applied Physics Letters Vol. 84, No. 10, 1653-1655 (2004)).

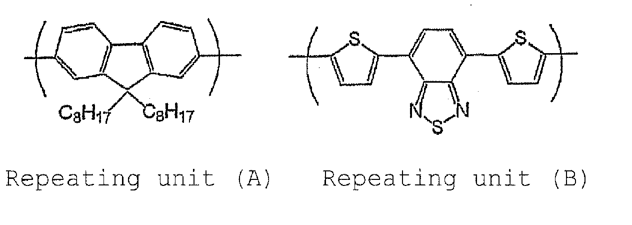

### DISCLOSURE OF THE INVENTION

However, a photoelectric conversion device such as an organic solar battery produced using the above composition does not necessarily exhibit sufficient conversion efficiency.

First, the present invention provides a composition comprising a first compound having a structure represented by formula (1), and a second compound composed of only a structure different from the structure represented by formula (1).

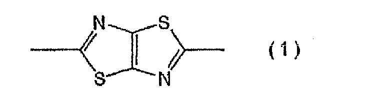

Second, the present invention provides a composition ink comprising the above composition and a solvent.

Third, the present invention provides a device comprising a first electrode and a second electrode, and an active layer between the first electrode and the second electrode, the active layer containing the above composition.

Fourth, the present invention provides a method for producing a device including a first electrode and a second electrode, and an active layer between the first electrode and the second electrode, the method comprising steps of applying the composition ink on the first electrode by an applying method to form the active layer, and forming the second electrode on the active layer.

### MODE FOR CARRYING OUT THE INVENTION

The present invention will be described in detail below.

The composition of the present invention contains a first compound having a structure represented by formula (1).

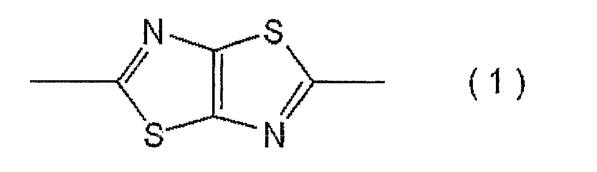

The structure represented by formula (1) is a divalent group represented by formula (1). Two bonds of this group combine with an atom such as a hydrogen atom or a halogen atom, a structure represented by formula (1) or a structure different from the structure represented by formula (1).

The first compound may be a compound containing one structure represented by formula (1), or may be a compound containing a plurality of structures represented by formula (1). The first compound contained in the composition of the present invention may be a low-molecular compound, or may be a polymer compound.

The first compound contained in the composition of the present invention may include, in addition to the structure represented by formula (1), a structure different from the structure represented by formula (1).

Examples of the structure different from the structure represented by formula (1) include a monovalent aromatic group, a divalent aromatic group, and a trivalent aromatic group.

The total of the formula weight of the structure represented by formula (1) is usually from 0.0001 to 0.5, preferably from 0.0005 to 0.4, and more preferably from 0.001 to 0.3, based on the molecular weight of the compound of the present invention. When the compound of the present invention is a polymer compound, the molecular weight is a polystyrene-equivalent number average molecular weight.

In the compound of the present invention, the structures represented by formula (1) may combine with each other directly or through other conjugate-forming unit, the structures different from the structure represented by formula (1) may combine with each other directly or through other conjugate-forming unit, and the structure different from the structure represented by formula (1) may combine with the structure represented formula (1) directly or through other conjugate-forming unit. As used herein, the conjugate in the present invention refers to a state where an unsaturated bond, a single bond and an unsaturated bond are associated in this order and two π bonds of a π-orbital are next to each other, and the respective π-electrons are arranged in parallel and are not localized on a double bond or a triple bond but spread over a neighboring single bond and are delocalized. As used herein, the unsaturated bond refers to a double bond or a triple bond. Examples of the conjugate-forming unit include an alkenylene group and an alkynylene group. Examples of the alkenylene group include a vinylene group, a propynylene group, a butenylene group, and a stynylene group. Examples of the alkynylene group include an ethynylene group.

The structure different from the structure represented by formula (1) preferably has aromaticity, and more preferably constructs a resonance structure with the structure represented by formula (1) directly or through other conjugate-forming unit.

Examples of the structure different from the structure represented by formula (1) include structures represented by formulas (2) to (124).

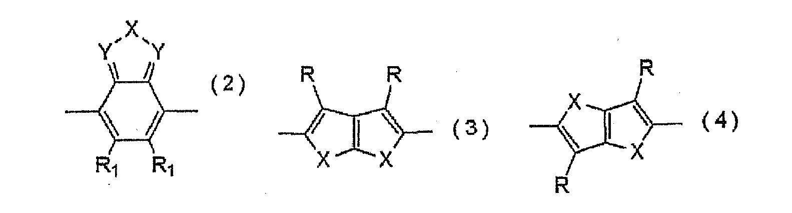

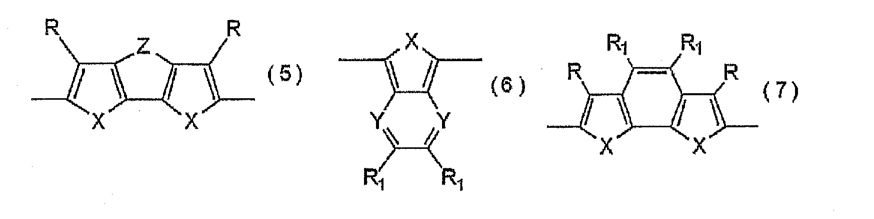

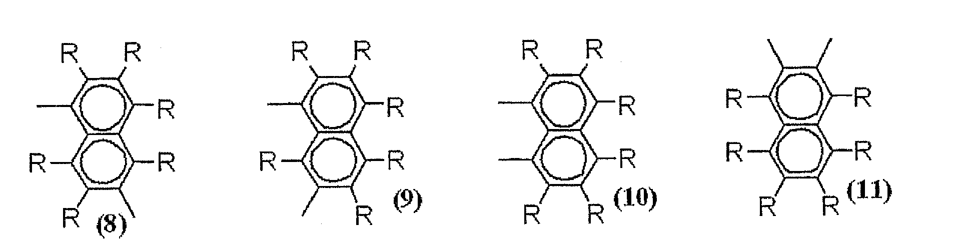

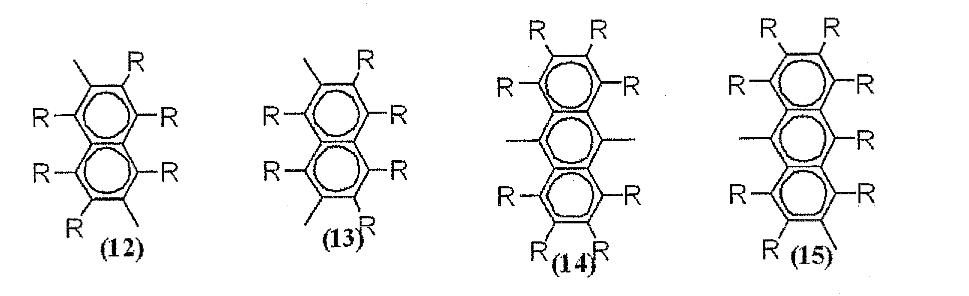

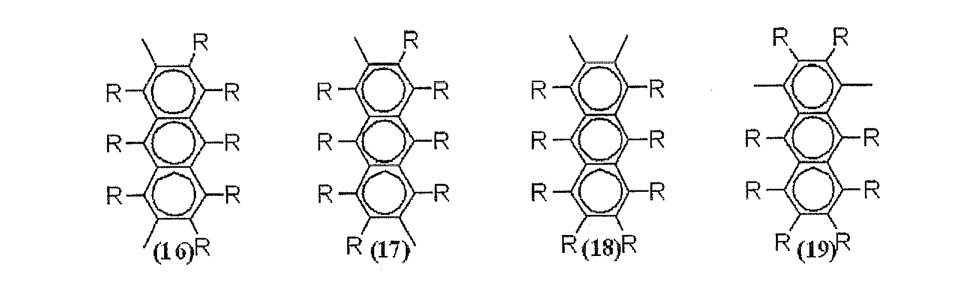

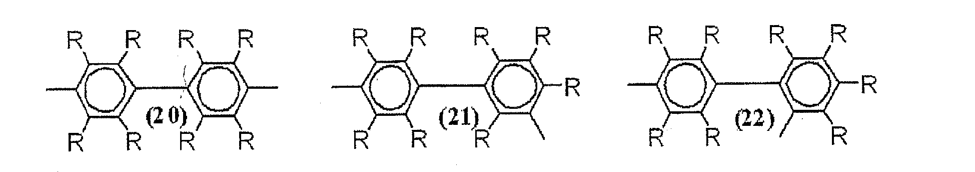

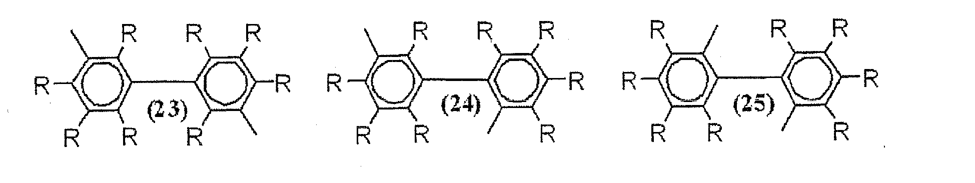

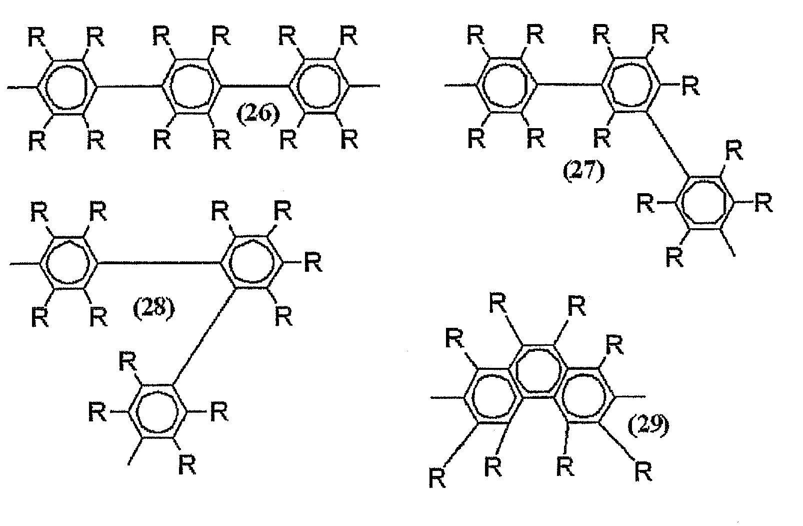

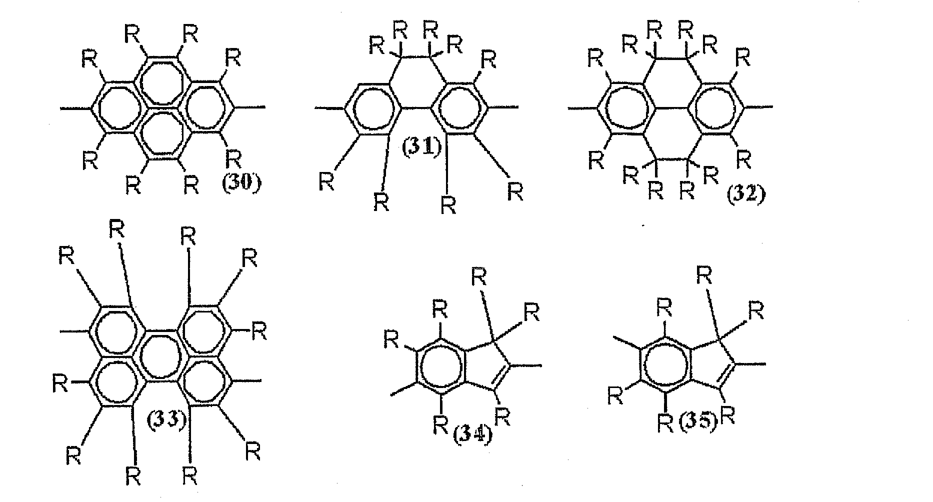

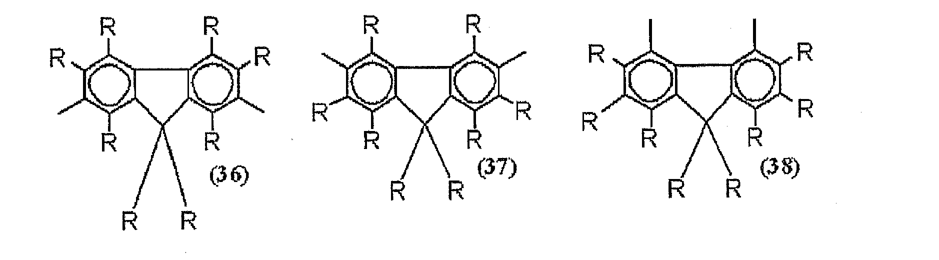

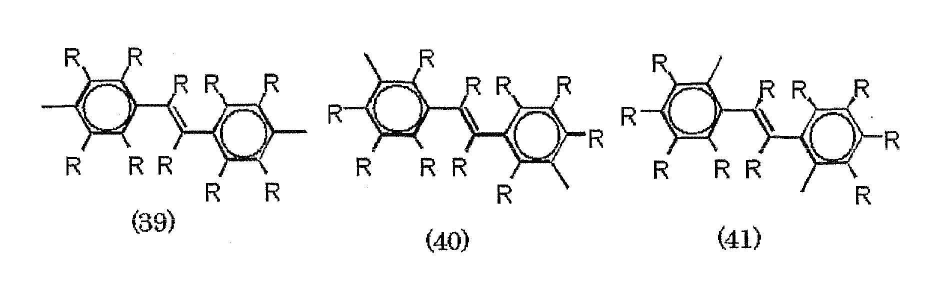

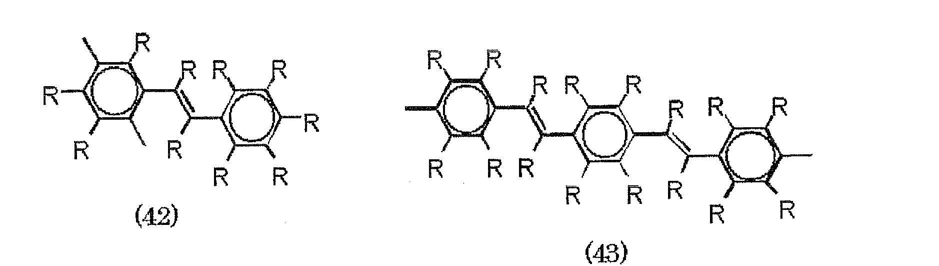

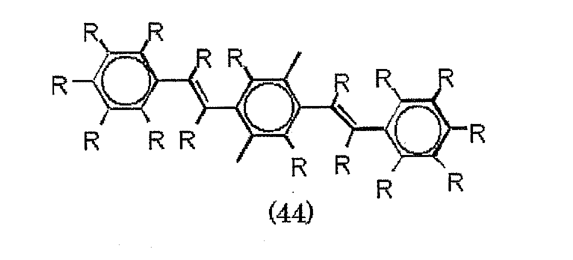

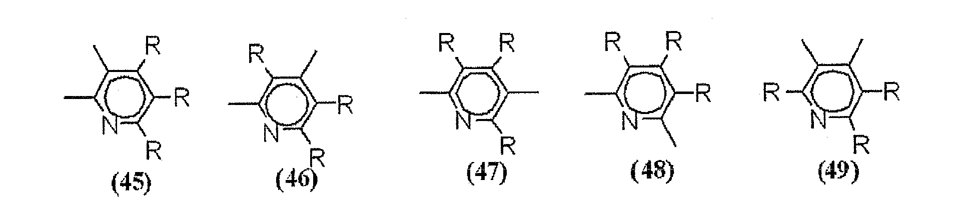

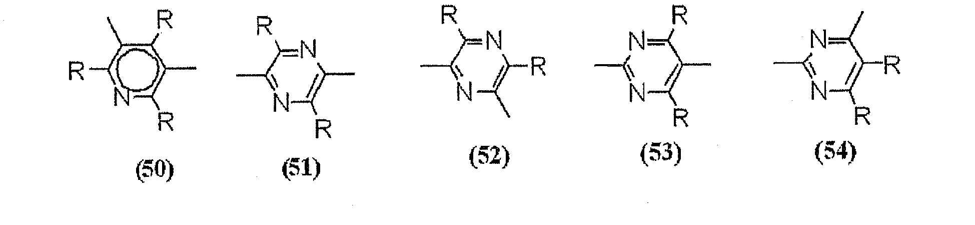

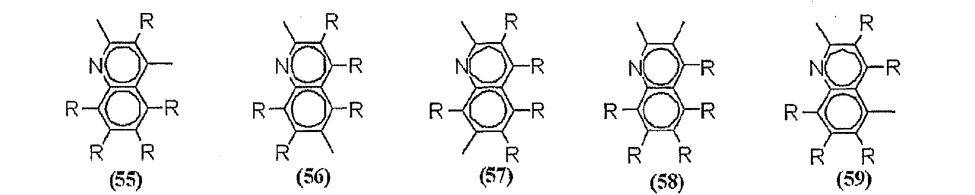

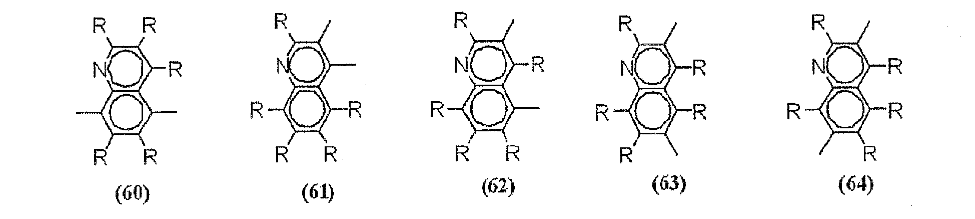

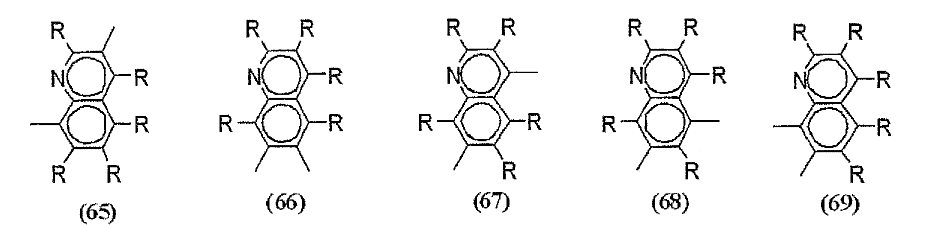

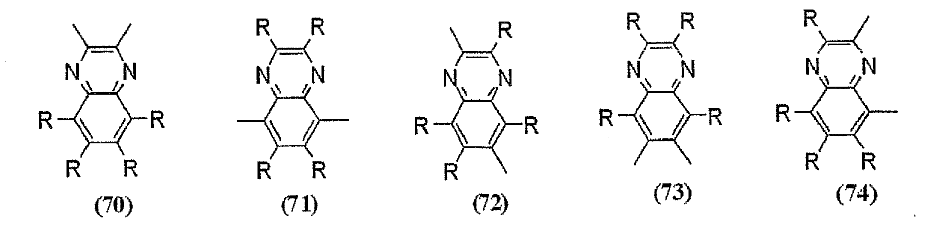

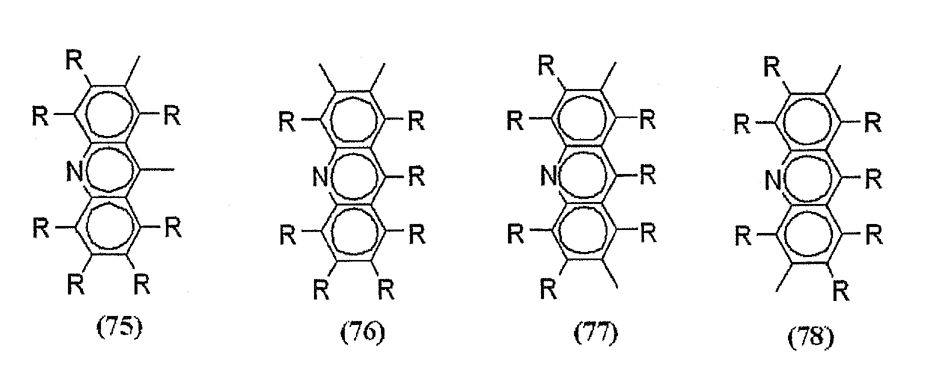

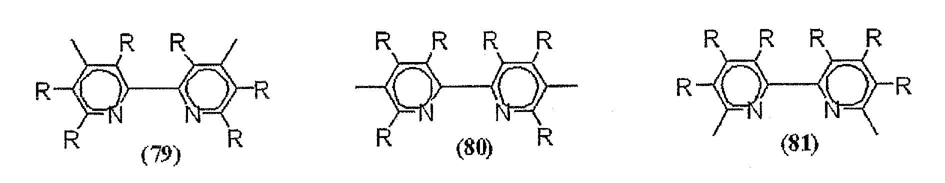

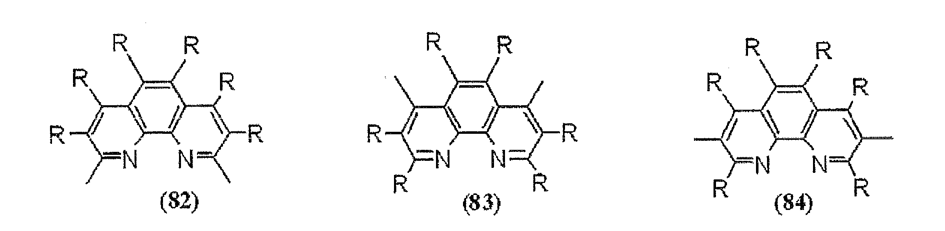

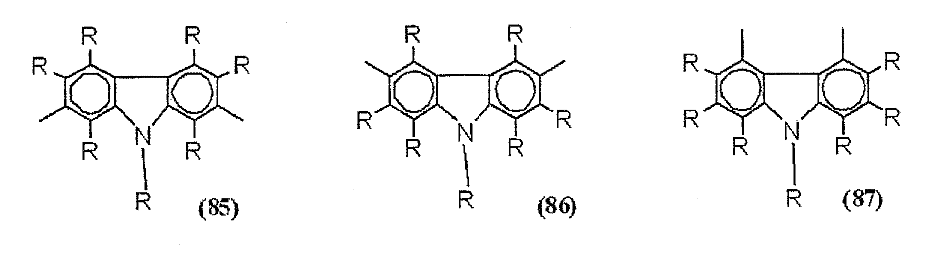

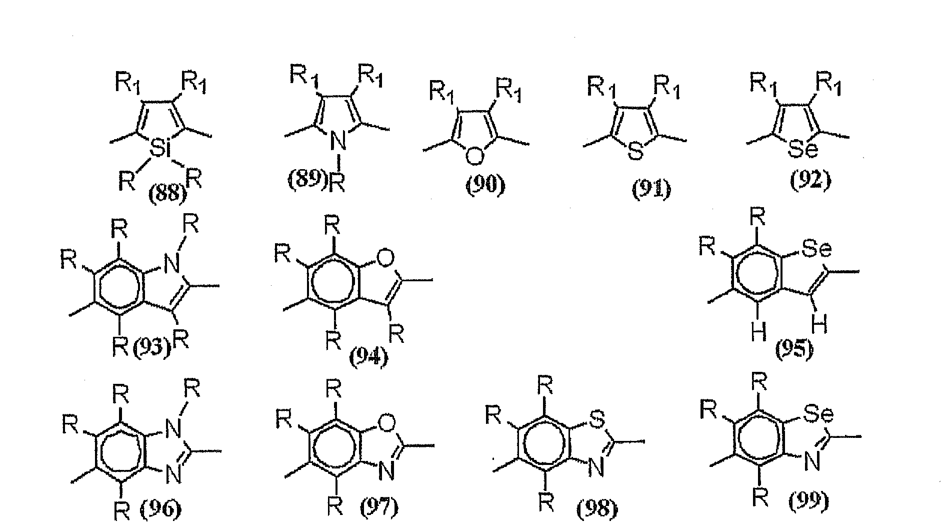

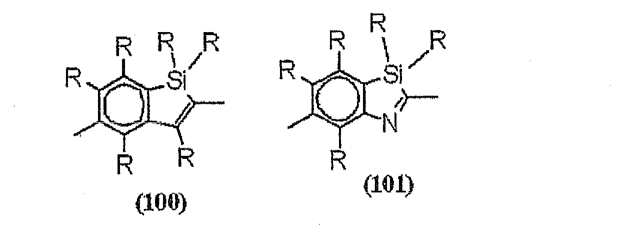

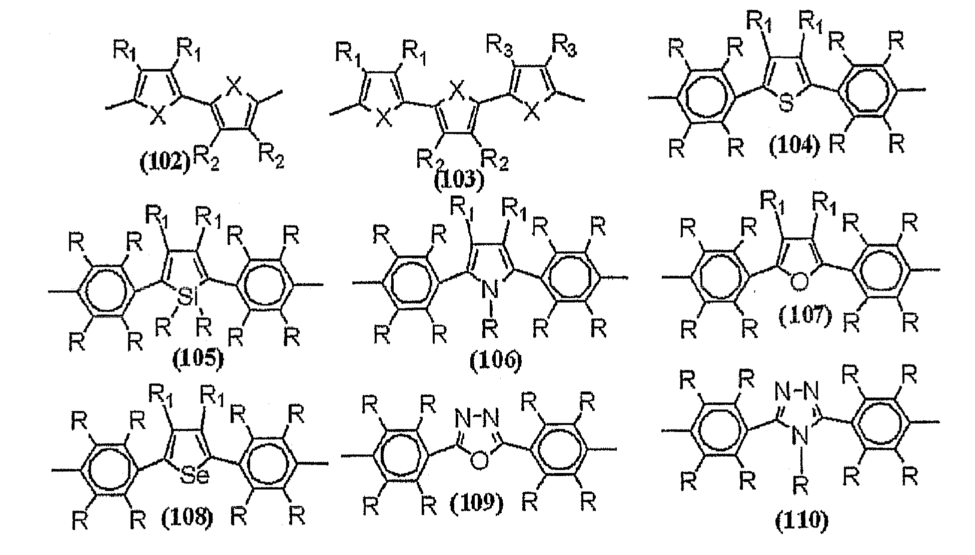

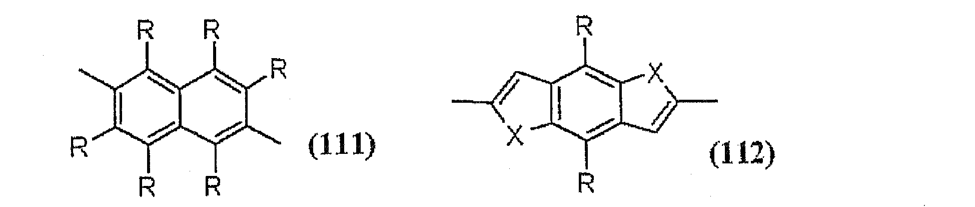

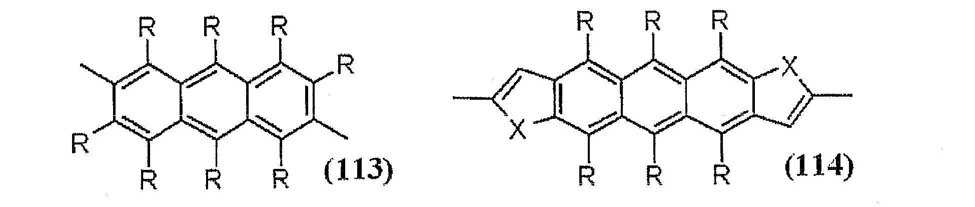

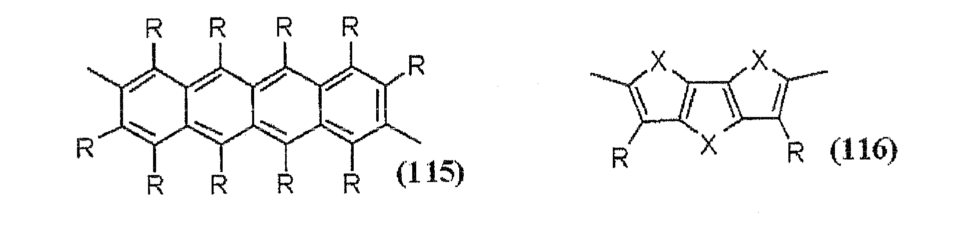

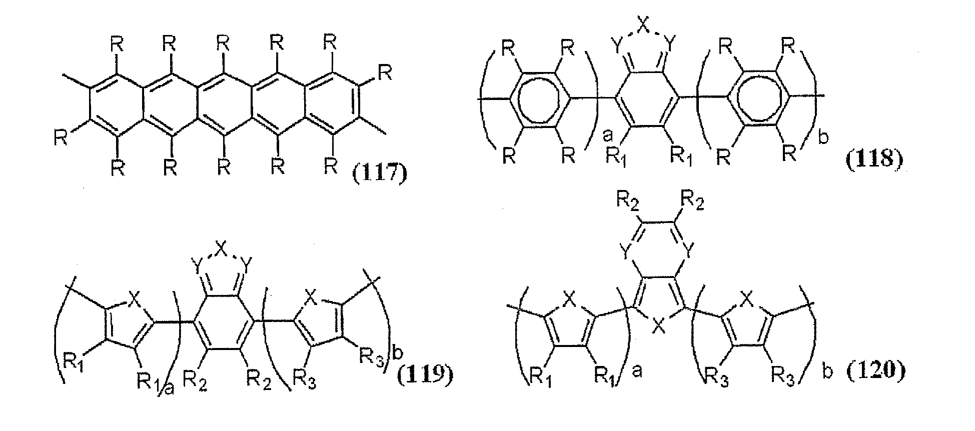

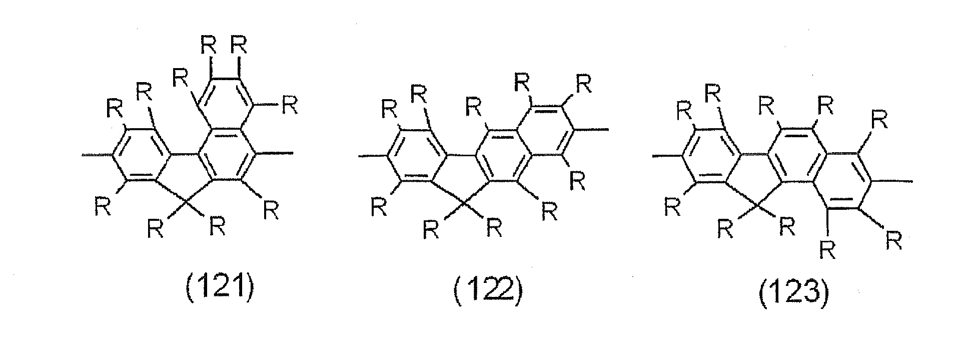

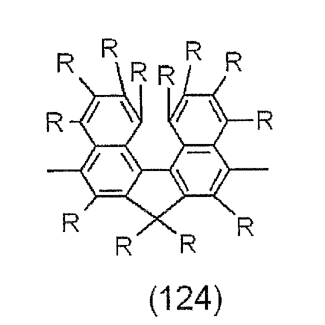

In formulas (2) to (124), X's are the same or different and represent a sulfur atom, an oxygen atom, a selenium atom, -N(R₁₀)- or -CR₁₁=CR₁₂-. When a plurality of X's are present, they may be the same or different. R₁₀, R₁₁ and R₁₂ are the same or different and represent a hydrogen atom or a substituent. When R₁₀, R₁₁ and R₁₂ are substituents, examples of the substituent include alkyl groups such as a methyl group, an ethyl group, a butyl group, a hexyl group, an octyl group, and a dodecyl group; and aryl groups such as a phenyl group and a naphthyl group. X is preferably a sulfur atom.

Y represents a nitrogen atom or =CH-. When a plurality of Y's are present, they may be the same or different. Y is preferably a nitrogen atom.

R, R₁, R₂ and R₃ are the same or different and represent a hydrogen atom or a substituent. When a plurality of R's, R₁'s, R₂'s and R₃'s are present, they may be the same or different. When R is a substituent, examples thereof include an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, a substituted amino group, a silyl group, a substituted silyl group, a halogen atom, an acyl group, an acyloxy group, an amide group, a monovalent heterocyclic group, a carboxyl group, a substituted carboxyl group, a nitro group, and a cyano group. The hydrogen atom(s) contained in these substituents may be substituted with a fluorine atom(s).

As the alkyl group, a group having 1 to 30 carbon atoms is usually used, and examples thereof include chain alkyl groups such as a methyl group, an ethyl group, a n-propyl group, an isopropyl group, a n-butyl group, an isobutyl group, a sec-butyl group, a t-butyl group, a n-pentyl group, an isopentyl group, a 2-methylbutyl group, a 1-methylbutyl group, a n-hexyl group, an isohexyl group, a 3-methylpentyl group, a 2-methylpentyl group, a 1-methylpentyl group, a heptyl group, an octyl group, an isooctyl group, a 2-ethylhexyl group, a nonyl group, a decyl group, an undecyl group, a dodecyl group, a tetradecyl group, a hexadecyl group, an octadecyl group, and an eicosyl group; and cycloalkyl groups such as a cyclopentyl group, a cyclohexyl group, and an adamantyl group.

As the alkoxy group, a group having 1 to 30 carbon atoms is usually used, and examples thereof include a methoxy group, an ethoxy group, a propoxy group, an isopropoxy group, a butoxy group, a cyclopentyloxy group, and a cyclohexyloxy group.

As the alkylthio group, a group having 1 to 24 carbon atoms is usually used, and examples thereof include a methylthio group, an ethylthio group, a propylthio group, an octylthio group, a decylthio group, a dodecylthio group, a tetradecylthio group, a hexadecylthio group, an octadecylthio group, an eicosylthio group, a docosylthio group, and a tetracosylthio group.

As the aryl group, a group having 6 to 20 carbon atoms is usually used, and examples thereof include a phenyl group, a naphthyl group, an anthryl group, and a pyrene group.

As the aryloxy group, a group having 6 to 20 carbon atoms is usually used, and examples thereof include a phenoxy group and a naphthoxy group.

As the arylthio group, a group having 6 to 20 carbon atoms is usually used, and examples thereof include a phenylthio group and a naphthylthio group.

As the arylalkyl group, a group having 7 to 20 carbon atoms is usually used, and examples thereof include a benzyl group and a phenethyl group.

As the arylalkoxy group, a group having 7 to 20 carbon atoms is usually used, and examples thereof include a phenoxy group, an o-, m- or p-tolyloxy group, a 1- or 2-naphthoxy group, and an anthroxy group.

As the arylalkylthio group, a group having 7 to 20 carbon atoms is usually used, and examples thereof include a benzylthio group and a phenylethylthio group.

As the arylalkenyl group, a group having 8 to 20 carbon atoms is usually used, and examples thereof include a styryl group.

As the arylalkynyl group, a group having 8 to 20 carbon atoms is usually used, and examples thereof include a phenylacetylenyl group.

Examples of the substituted amino group (-NQ¹₂, Q¹ represents a substituent such as an alkyl group, an aryl group or a monovalent heterocyclic group, or a hydrogen atom, and at least one Q¹ is a substituent) include a monoalkylamino group, a dialkylamino group, a monoarylamino group, and a diarylamino group. Examples of the alkyl group and the aryl group contained in the substituted amino group include the same groups as those described above. The substituted amino group usually has 1 to 10 carbon atoms.

Examples of the substituted silyl group (-SiQ²₃, Q² represents a substituent such as an alkyl group, an aryl group or a monovalent heterocyclic group, or a hydrogen atom, and at least one Q² is a substituent) include a silyl group substituted with an alkyl group, an aryl group and the like. Examples of the alkyl group and the aryl group contained in the substituted silyl group include the same groups as those described above. The substituted silyl group usually has 1 to 18 carbon atoms.

Examples of the halogen atom include a fluorine atom, a chlorine atom, a bromine atom, and an iodine atom.

As the acyl group, a group having 1 to 20 carbon atoms is usually used, and examples thereof include a formyl group, an acetyl group, a propanoyl group, and a butanoyl group.

As the acyloxy group, a group having 2 to 20 carbon atoms is usually used, and examples thereof include a butyryloxyethyl group.

It is possible to use, as the amide group, a non-substituted amide group represented by -CONH₂, an amide group represented by -CON(R⁵⁰⁰)₂ (R⁵⁰⁰ represents an alkyl group or an aryl group, and two R⁵⁰⁰'s may be the same or may be different with each other) substituted with an alkyl group or an aryl group, and the like. Examples of the alkyl group and the aryl group contained in the amide group include the same groups as those described above. The amide group usually has 1 to 18 carbon atoms.

Examples of the monovalent heterocyclic group include a group in which one hydrogen atom is removed from a heterocyclic compound. The monovalent heterocyclic group usually has 4 to 20 carbon atoms.

Examples of the heterocyclic compound include furan, thiophene, pyrrole, pyrroline, pyrrolidine, oxazole, isoxazole, thiazole, isothiazole, imidazole, imidazoline, imidazolidine, pyrazole, pyrazoline, pyrazolidine, furazan, triazole, thiadiazole, oxadiazole, tetrazole, pyran, pyridine, piperidine, thiopyran, pyridazine, pyrimidine, pyrazine, piperazine, morpholine, triazine, benzofuran, isobenzofuran, benzothiophene, indole, isoindole, indolizine, indoline, isoindoline, chromene, chroman, isochroman, benzopyran, quinoline, isoquinoline, quinolizine, benzoimidazole, benzothiazole, indazole, naphthyridine, quinoxaline, quinazoline, quinazolidine, cinnoline, phthalazine, purine, pteridine, carbazole, xanthene, phenanthridine, acridine, β-carboline, perimidine, phenanthroline, thianthrene, phenoxathiin, phenoxazine, phenothiazine, and phenazine. The monovalent heterocyclic group is preferably a monovalent aromatic heterocyclic group.

As the substituted carboxyl group (a group represented by -COOQ³ (Q³ represents a substituent such as an alkyl group, an aryl group, or a monovalent heterocyclic group)), a group having 2 to 20 carbon atoms is usually used, and examples thereof include a methoxycarbonyl group (methyl ester), an ethoxycarbonyl group (ethyl ester), and a butoxycarbonyl group (butyl ester).

Specific examples of the case where R₁, R₂ and R₃ are substituents include the same groups as those in the case where R is a substituent.

When two R₁'s are included in formulas (2) to (124), the respective R₁'s may combine with each other to form a cyclic structure. When two R₂'s are included, the respective R₂'s may combine with each other to form a cyclic structure. When two R₃'s are included, the respective R₃'s may combine with each other to form a cyclic structure. Specific examples of such a cyclic structure include the following structures: 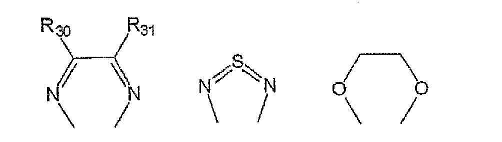 wherein R₃₀ and R₃₁ may be the same or different and represent a hydrogen atom or a substituent.

Examples of the substituents represented by R₃₀ and R₃₁ include the same groups as those represented by R described above.

In formulas (2) to (124), Z represents a sulfur atom, an oxygen atom, a selenium atom, -N(R₂₀)-, -Si(R₂₁R₂₂)- or - C(R₂₃R₂)-. R₂₀ to R₂₄ are the same or different and represent a hydrogen atom or a substituent. R₂₁ and R₂₂ may combine to form a cyclic structure. R₂₃ and R₂₄ may combine to form a cyclic structure.

When R₂₀ to R₂₄ are substituents, examples of the substituent include alkyl groups such as a methyl group, an ethyl group, a butyl group, a hexyl group, a heptyl group, an octyl group, a nonyl group, a decyl group, an undecyl group, a dodecyl group, a tridecyl group, a tetradecyl group, a pentadecyl group, a hexadecyl group, a heptadecyl group, an octadecyl group, a nonadecyl group, and an eicosyl group; and aryl groups such as a phenyl group and a naphthyl group. R₂₀ to R₂₄ are preferably hydrocarbon groups, and more preferably alkyl groups. When R₂₀ to R₂₄ are substituents, the substituent preferably has 4 or more carbon atoms, and more preferably 6 or more carbon atoms.

Z₁ is preferably -Si(R₂₁R₂₂)- or -C(R₂₃R₂₄)-, and more preferably -C(R₂₃R₂₄)-.
a and b are the same or different and represent the number of repeating units, and are usually 1 to 5, preferably from 1 to 3, and more preferably 1.

Among the structures represented by formulas (2) to (124), the structures represented by formulas (2) to (7), (91), (102), (103), (112), (116), (119) and (120) are preferable, the structures represented by formulas (2) to (7), (91), (102), (103) and (112) are more preferable, the structures represented by formulas (2) to (7) are still more preferable, and the structure represented by formula (2) is particularly preferable.

When the compound of the present invention has two or more structures represented by formula (1) in one molecule and also has a structure other than the structure represented by formula (1), it is preferred that the structure represented by formula (1) does not continue from the viewpoint of improving photoelectric conversion efficiency.

The first compound included in the present invention preferably contains a repeating unit represented by formula (1-1).

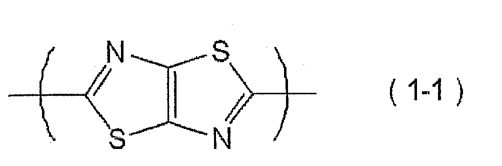

The first compound may further contain a repeating unit represented by formula (20): 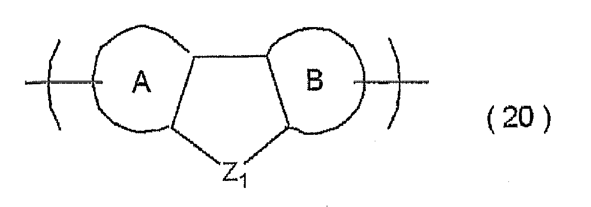 wherein a ring A and a ring B are the same or different and represent an aromatic ring, and Z₁ has the same meaning as defined in the above Z.

Examples of the rings A and B include aromatic hydrocarbon rings such as a benzene ring and a naphthalene ring; and aromatic heterocycles such as thiophene. Both rings A and B are preferably aromatic rings, more preferably 4- to 7-membered rings, and still more preferably benzene rings or naphthalene rings.

Among the repeating units represented by formula (20), a repeating unit represented by formula (20-1): 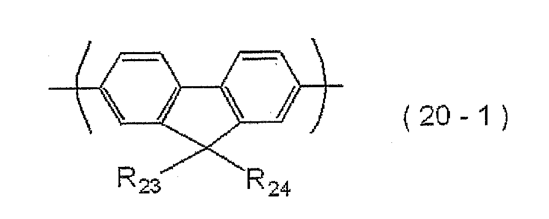 wherein R₂₃ and R₂₄ have the same meaning as defined above; is preferred.

The first compound may be a compound having any molecular weight and is preferably a polymer compound. In the present invention, the polymer compound refers to a compound having a weight average molecular weight of 3,000 or more and a polymer compound having a weight average molecular weight of 3,000 to 10,000,000 is preferably used. When the weight average molecular weight is less than 3,000, defects may be likely caused in the formation of a film upon the production of a device. In contrast, when the weight average molecular weight is more than 10,000,000, solubility in a solvent and applicability upon the production of a device may likely deteriorate. The weight average molecular weight is more preferably from 8,000 to 5,000,000, and particularly preferably from 10,000 to 1,000,000.

The weight average molecular weight in the present invention refers to a polystyrene-equivalent weight average molecular weight calculated by gel permeation chromatography (GPC) using polystyrene standard samples.

The content of the first compound in the composition of the present invention is appropriately selected within a range of more than 0% by weight and less than 100% by weight depending on the purposes, and is preferably from 0.01% by weight to 90% by weight, more preferably from 0.05% by weight to 80% by weight, and particularly preferably from 0.1% by weight to 80% by weight.

At least one structure represented by formula (1) in the first compound may be contained in the compound. When the first compound is a polymer compound, the polymer compound preferably contains two or more structures on average per one polymer chain, and more preferably three or more structures on average per one polymer chain.

When the first compound is used as a device, it preferably has high solubility in solvent from the viewpoint of ease of the production of a device. Specifically, the first compound preferably has solubility so as to enable the preparation of a solution containing 0.01% by weight or more of the first compound, more preferably solubility so as to enable the preparation of a solution containing 0.1% by weight or more of the first compound, and still more preferably solubility so as to enable the preparation of a solution containing 0.4% by weight or more of the first compound.

When the first compound contained in the composition of the present invention is a polymer compound and the polymer compound is used in a photoelectric conversion device, the polymer compound preferably has a light absorption end wavelength of 600 nm or more from the viewpoint of conversion efficiency.

The light absorption end wavelength in the present invention means the value determined by the following method.

In the measurement, a spectrophotometer capable of operating in an ultraviolet, visible or near infrared wavelength range (for example, UV-visible near infrared spectrophotometer JASCO-V670 manufactured by JASCO Corporation) is used. When JASCO-V670 is used, since a measurable wavelength is in a range from 200 to 1,500 nm, the measurement is made in the above wavelength range. First, an absorption spectrum of a substrate to be used in the measurement is measured. As the substrate, a quartz substrate, a glass substrate, and the like are used. Next, a thin film containing a first compound is formed from a solution containing the first compound or a melt containing the first compound on the substrate. In the formation of a film from a solution, drying is performed after the formation of the film. Then, an absorption spectrum of a laminate of the thin film and the substrate is obtained. A difference between the absorption spectrum of the laminate of the thin film and the substrate, and the absorption spectrum of the substrate is obtained as the absorption spectrum of the thin film. With respect to the absorption spectrum of the thin film, the ordinate denotes an absorbance of the first compound and the abscissas denotes a wavelength. It is desired to adjust the film thickness of the thin film so that the absorbance of the largest absorption peak is around 0.5 to 2. It is assumed that an absorbance of an absorption peak at the longest wavelength among the absorption peaks is 100%, and that an intersection point between a straight line parallel to the abscissas (wavelength axis) including 50% of the absorbance, and the absorption peak, which is on a wavelength longer than the peak wavelength of the absorption peak, is a first point. It is assumed that an intersection point between a straight line parallel to a wavelength axis including 25% of the absorbance, and the absorption peak, which is on a wavelength longer than the peak wavelength of the absorption peak, is a second point. An intersection point between a straight line connecting the first point and the second point, and a base line is defined as a light absorption end wavelength. As used herein, the base line refers to a straight line connecting a third point on an absorption spectrum having a wavelength which is 100 nm longer than a base wavelength and a fourth point on an absorption spectrum having a wavelength which is 150 nm longer than a base wavelength, assuming that the base wavelength is a wavelength of an intersection point between a straight line parallel to a wavelength axis containing 10% of an absorbance of an absorption peak (100%) at the longest wavelength, and the absorption peak, a wavelength of the intersection point being longer than the peak wavelength of the absorption peak.

When the composition of the present invention contains a polymer compound as a first compound, and the composition is used in a photoelectric conversion device, the light absorption end wavelength of the polymer compound is preferably 600 nm or more, more preferably 650 nm or more, still more preferably 700 nm or more, and particularly preferably 720 nm or more, from the viewpoint of conversion efficiency.

Examples of the polymer compound whose light absorption end wavelength is 600 nm or more include a polymer compound containing, in addition to the structure represented by formula (1), the structures represented by formulas (2) to (7).

When the first compound is a polymer compound, the method of producing a polymer compound is not particularly limited and is preferably a method using the Suzuki coupling reaction from the viewpoint of ease of the synthesis of a polymer compound.

Examples of the method using the Suzuki coupling reaction include a production method comprising a step of reacting one or more compounds represented by formula (100):

Q₁-E₁-Q₂ (100)

wherein E₁ represents a structure unit including the groups represented by formulas (2) to (7), and Q₁ and Q₂ are the same or different and represent a boric acid residue (-B(OH)₂) or a boric acid ester residue, with one or more compounds represented by formula (200):

T₁-E₂-T₂ (200)

wherein E₂ represents a structure unit including the group represented by formula (1), and T₁ and T₂ are the same or different and represent a halogen atom, an alkylsulfonate group, an arylsulfonate group, or an arylalkylsulfonate group, in the presence of a palladium catalyst and a base.

In this case, the total of the number of mols of one or more compounds represented by formula (200) used in the reaction is preferably excessive based on the total of the number of mols of one or more compounds represented by formula (100). Assuming that the total of the number of mols of one or more compounds represented by formula (200) used in the reaction is 1 mol, the total of the number of mols of one or more compounds represented by formula (100) is preferably from 0.6 to 0.99 mol, and more preferably from 0.7 to 0.95 mol.

Examples of the boric acid ester residue include groups represented by the formulas illustrated below: 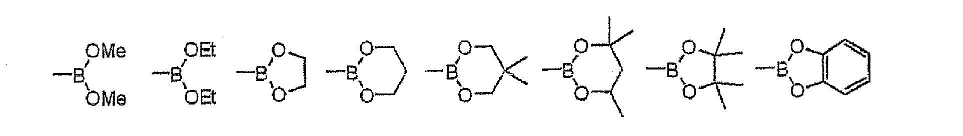 wherein Me represents a methyl group and Et represents an ethyl group.

In formula (200), examples of the halogen atom in T¹ and T² include a fluorine atom, a chlorine atom, a bromine atom and an iodine atom. From the viewpoint of ease of the synthesis of a polymer compound, the halogen atom is preferably a bromine atom or an iodine atom, and more preferably a bromine atom.

In formula (200), examples of the alkylsulfonate group in T¹ and T² include a methanesulfonate group, an ethanesulfonate group, and a trifluoromethanesulfonate group. Examples of the arylsulfonate group include a benzenesulfonate group and a p-toluenesulfonate group. Examples of the arylsulfonate group include a benzylsulfonate group.

Using palladium[tetrakis(triphenylphosphine)], palladium acetates, dichlorobis(triphenylphosphine)palladium(II) and the like as the catalyst, inorganic bases such as potassium carbonate, sodium carbonate, and barium hydroxide, organic bases such as triethylamine, and inorganic salts such as cesium fluoride are added in the amount of equivalent or more, and preferably from 1 to 20 equivalents, relative to a monomer as a raw material, and then reacted. Examples of the solvent include N,N-dimethylformamide, toluene, dimethoxyethane, and tetrahydrofuran. The base is added in the form of an aqueous solution, and the reaction may be performed in a two-phase system. When the reaction may be performed in the two-phase system, if necessary, a phase transfer catalyst such as a quaternary ammonium salt may be added. The reaction temperature varies depending on the solvent, and the temperature of around 50 to 160°C is suitably used. Refluxing may be performed by raising the temperature to around a boiling point of the solvent. The reaction time is from around 0.1 to 200 hours. The reaction is performed in an inert atmosphere such as an argon gas or a nitrogen gas under the conditions where the catalyst is not deactivated.

Examples of the palladium catalyst used in the method of producing a polymer compound, which can be used in the present invention, include palladium[tetrakis(triphenylphosphine)], palladium acetates, and dichlorobis(triphenylphosphine)palladium(II), including a Pd(0) catalyst, a Pd(II) catalyst and the like. From the viewpoint of ease of the reaction (polymerization) operation and the reaction (polymerization) rate, dichlorobis(triphenylphosphine)palladium(II) and palladium acetates are preferred.

The additive amount of the palladium catalyst is not particularly limited and may be an effective amount as the catalyst, and is usually from 0.0001 mol to 0.5 mol, and preferably from 0.0003 mol to 0.1 mol, based on 1 mol of the compound represented by formula (100).

### •Base

Examples of the base used in the production of a polymer compound, which can be used in the present invention, include an inorganic base, an organic base, and an inorganic salt. Examples of the inorganic base include potassium carbonate, sodium carbonate, and barium hydroxide. Examples of the organic base include triethylamine and tributylamine. Examples of the inorganic salt include cesium fluoride.

The additive amount of the base usually from 0.5 mol to 100 mol, preferably from 0.9 mol to 20 mol, and more preferably from 1 mol to 10 mol, based on 1 mol of the compound represented by formula (100).

When palladium acetates are used as the palladium catalyst, for example, phosphorus compounds such as triphenylphosphine, tri(o-tolyl)phosphine, and tri(o-methoxyphenyl)phosphine can be added as a ligand. In this case, the additive amount of the ligand is usually from 0.5 mol to 100 mol, preferably from 0.9 mol to 20 mol, and more preferably from 1 mol to 10 mol, based on 1 mol of the palladium catalyst.

In the method of producing a polymer compound which can be used in the present invention, the reaction is usually performed in a solvent. Examples of the solvent include N,N-dimethylformamide, toluene, dimethoxyethane, and tetrahydrofuran. From the viewpoint of solubility of the polymer compound used in the present invention, toluene and tetrahydrofuran are preferred. The base is added in the form of an aqueous solution, and the reaction may be performed in a two-phase system. When the inorganic salt is used as the base, the base is usually added in the form of an aqueous solution from the viewpoint of solubility of the inorganic salt, and the reaction is performed in the two-phase system,

When the base is added in the form of an aqueous solution and the reaction is performed in the two-phase system, if necessary, a phase transfer catalyst such as a quaternary ammonium salt may be added.

The temperature at which the reaction is performed varies depending on the solvent and is usually from around 50 to 160°C, and preferably from 60 to 120°C from the viewpoint of an increase in molecular weight of the polymer compound. Refluxing may be performed by raising the temperature to around a boiling point of the solvent.

When the polymerization degree reaches the objective polymerization degree, the reaction may be regarded as the end point thereof, and the time during which the reaction is performed (reaction time) is usually from around 0.1 hours to 200 hours, and preferably from around 1 hour to 30 hours from the viewpoint of satisfactory efficiency.

The reaction is performed under an inert atmosphere such as an argon gas or a nitrogen gas in a reaction system in which a Pd(0) catalyst is not deactivated. For example, the reaction is performed in a system which is sufficiently deaerated by an argon gas, a nitrogen gas and the like. Specifically, after deaeration by sufficiently replacing the atmosphere inside a polymerization vessel (a reaction system) with a nitrogen gas, a compound represented by formula (100), a compound represented by formula (200) and dichlorobis(triphenylphosphine)palladium(II) are charged in the polymerization vessel. Furthermore, after deaeration by sufficiently replacing the atmosphere inside the polymerization vessel with a nitrogen gas, a solvent deaerated in advance by bubbling a nitrogen gas, for example, toluene is added. Then, to this solution, a base deaerated in advance by bubbling a nitrogen gas, for example, an aqueous sodium carbonate solution was added dropwise, and then the temperature is raised by heating and the polymerization is performed at a reflux temperature for 8 hours while maintaining an inert atmosphere.

The polystyrene-equivalent number average molecular weight of the polymer compound, which can be used in the present invention, is preferably from 1 × 10³ to 1 × 10⁸, and more preferably from 2 × 10³ to 1 × 10⁷. When the polystyrene-equivalent number average molecular weight is 1 × 10³ or more, it becomes easy to obtain a tough thin film. In contrast, when the polystyrene-equivalent number average molecular weight is 10⁸ or less, it is easy to form a thin film because of high solubility.

The polystyrene-equivalent weight average molecular weight is preferably 3.0 × 10³ or more, and more preferably 1.0 × 10⁴ or more. The weight average molecular weight is more preferably within a range from 1.0 × 10⁴ to 1.0 × 10⁷.

When a polymerization active group remains as it is in a terminal group of a polymer compound which can be used in the present invention, characteristics and lifetime of a device obtained when used in the production of the device may deteriorate, and therefore the terminal group may be protected with a stable group. The terminal group having a conjugated bond contiguous with a conjugated structure of a main chain is preferred and, for example, it may have a structure which combines with an aryl group or a heterocyclic group through a vinylene group. Specifically, it is exemplified by the substituents described in Chemical Formula 10 of JP-A-9-45478 and the like.

The composition of the present invention contains a second compound which does not have a structure represented by formula (1). The second compound is composed of only a structure different from the structure represented by formula (1).

Examples of the second compound include an electron-accepting compound and an electron-donating compound. Preferably, the second compound is an electron-accepting compound.

When the compound of the present invention is used in a photoelectric conversion device, the first compound can be used as the electron-donating compound. In that case, the second compound can be used as the electron-accepting compound. The electron-accepting compound preferably has a work function of 3.0 eV or more, more preferably 3.2 eV or more, and particularly preferably 3.4 eV or more. As used herein, the work function refers to an absolute value of the lowest unoccupied molecular orbital (LUMO) when a vacuum level is set at 0 eV.

Examples of the electron-accepting compound include titanium oxide, a carbon material such as carbon nano-tube, fullerene, a fullerene derivative, metal oxide, an oxadiazole derivative, anthraquinodimethane and a derivative thereof, benzoquinone and a derivative thereof, naphthoquinone and a derivative thereof, anthraquinone and a derivative thereof, tetracyanoanthraquinodimethane and a derivative thereof, a fluorenone derivative, diphenyldicyanoethylene and a derivative thereof, a diphenoquinone derivative, 8-hydroxyquinoline and a metal complex of a derivative thereof, polyquinoline and a derivative thereof, polyquinoxaline and a derivative thereof, polyfluorene and a derivative thereof, and a phenanthrene derivative such as 2,9-dimethyl-4,7-diphenyl-1,10-phenanthroline (bathocuproine), and the electron-accepting compound is preferably titanium oxide, carbon nano-tube, fullerene or a fullerene derivative, and particularly preferably fullerene or a fullerene derivative. Examples of fullerene and a fullerene derivative include C₆₀, C₇₀, C₈₄ and a derivative thereof. Specific structure of the fullerene derivative includes the followings.

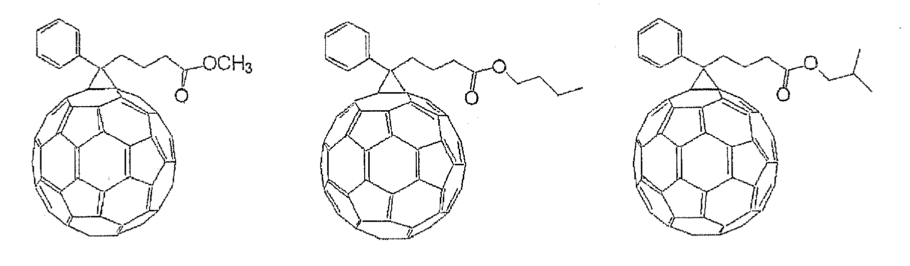

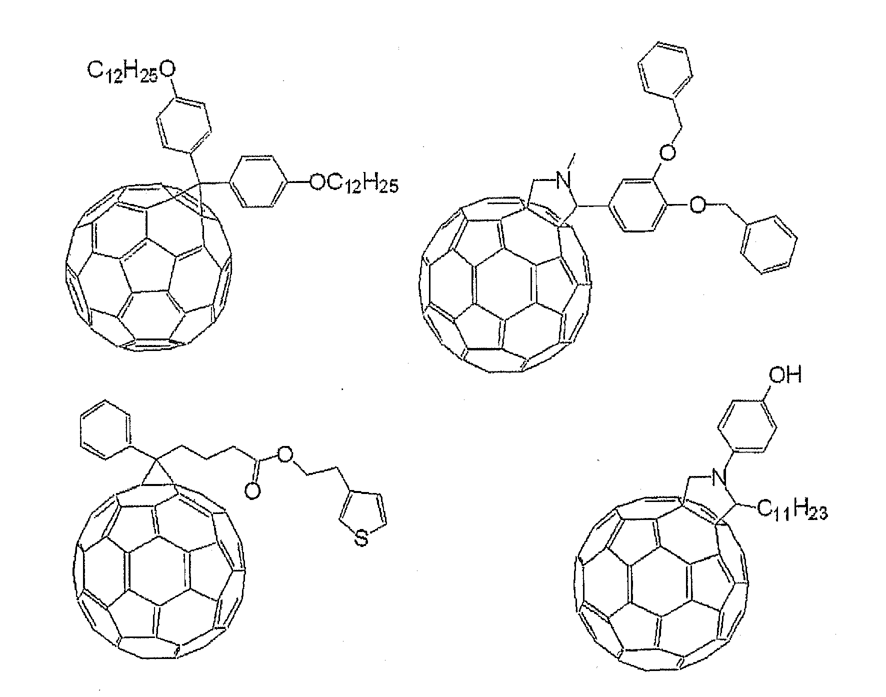

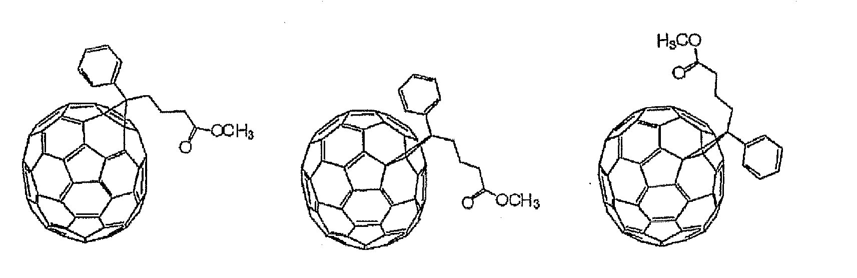

Examples of the electron-donating compound include a pyrazoline derivative, an arylamine derivative, a stilbene derivative, a triphenyldiamine derivative, oligothiophene and a derivative thereof, polyvinylcarbazole and a derivative thereof, polysilane and a derivative thereof, a polysiloxane derivative having an aromatic amine in a side chain or a main chain, polyaniline and a derivative thereof, polythiophene and a derivative thereof, polypyrrole and a derivative thereof, polyphenylenevinylene and a derivative thereof, and polythienylenevinylene and a derivative thereof.

The electron-donating compound and the electron-accepting compound are relatively determined from an energy level of energy levels of these compounds.

The composition of the present invention may contain, in addition to the first compound and the second compound, any compound as long as the object of the present invention is not adversely affected.

The composition ink of the present invention contains the composition and a solvent. From the viewpoint of solubility, examples of the solvent include an aromatic compound, an aliphatic hydrocarbon compound, an alcohol, ether, and a cyclic ether. Among these, the solvent is preferably one or more compounds selected from the group consisting of an aromatic compound having a substituent, a linear alkane, a branched alkane, a cycloalkane, a linear alcohol, a branched alcohol and an alicyclic alcohol, and more preferably a halogen-substituted aromatic hydrocarbon solvent. Examples of the halogen-substituted aromatic hydrocarbon solvent include chlorobenzene, dichlorobenzene, and trichlorobenzene, and the halogen-substituted aromatic hydrocarbon solvent is preferably dichlorobenzene, and particularly preferably orthodichlorobenzene.

From the viewpoint of ease of film formation, a surface tension at 25°C of the solvent is preferably more than 15 mN/m, more preferably more than 15 mN/m and less than 100 mN/m, and still more preferably more than 25 mN/m and less than 60 mN/m. Specific examples thereof include toluene (27.9 mN/m), benzonitrile (34.5 mN/m), 1,3-benzodioxole (28.8 mN/m), orthoxylene (29.8 mN/m), metaxylene (28.5 mN/m), paraxylene (28.0 mN/m), cyclohexanone (34.6 mN/m), chlorobenzene (33.0 mN/m), orthodichlorobenzene (36.7 mN/m), metadichlorobenzene (35.4 mN/m), paradichlorobenzene (32.5 mN/m), cis-decalin (32.2 mN/m), trans-decalin (29.9 mN/m), ethylbenzene (28.7 mN/m), 1,2,4-trimethylbenzene (29.2 mN/m), 1,3,5-trimethylbenzene (27.5 mN/m), chloroform (26.7 mN/m), tetradecane (26.1 mN/m), and ethylene glycol (48.4 mN/m). The numerical value in parenthesis denotes a surface tension at 25°C. As the surface tension, the value disclosed in "Lange's Handbook of Chemistry 13th edition", written and edited by John. A. Dean, McGaw-Hill, issued on 1972, pp.10/103-10/116 was described. When the first compound is a conjugate polymer compound, the solvent is preferably an aromatic compound having a substituent, and more preferably chlorobenzene, orthodichlorobenzene, metadichlorobenzene, paradichlorobenzene, orthoxylene, metaxylene, paraxylene or toluene, from the viewpoint of solubility of the conjugated polymer compound.

The content of the first compound in the composition ink is preferably from 0.01% by weight to 99.9% by weight, more preferably from 0.1% by weight to 50% by weight, still more preferably from 0.3% by weight to 30% by weight, and particularly preferably from 0.5% by weight to 10% by weight, in terms of a weight fraction in the composition ink.

The content of the second compound in the composition ink is in the range where the sum of the content of the second compound and the content of the first compound is less than 100% by weight based on the weight of the entire composition ink. The content of the second compound is preferably from 0.01% by weight to 99.9% by weight, more preferably from 0.1% by weight to 50% by weight, still more preferably from 0.3% by weight to 30% by weight, and particularly preferably from 0.5% by weight to 10% by weight.

When the composition of the present invention is used in the device, it can be used as an active layer that is an organic layer constituting the device.

Usually, the thickness of the organic layer is preferably from 1 nm to 100 µm, more preferably from 2 nm to 1,000 nm, still more preferably from 5 nm to 500 nm, and further preferably from 20 nm to 200 nm.

The organic layer may be formed by any method and examples thereof include a method of forming a film from a composition ink, and a method of forming a film using a vacuum deposition method. Examples of the solvent used in the formation of a film from a solution containing a composition include the same solvents as those contained in the composition ink.

A preferred method of producing a device is a method for producing a device including a first electrode and a second electrode, and an active layer between the first electrode and the second electrode, the method comprising a step of applying the composition ink on the first electrode by an applying method to form an active layer, and a step of forming the second electrode on the active layer.

When a film is formed using the composition ink, it is possible to use applying methods such as a slit coating method, a spin coating method, a casting method, a microgravure coating method, a gravure coating method, a bar coating method, a roll coating method, a wire bar coating method, a dip coating method, a knife coating method, a spray coating method, a screen printing method, a gravure printing method, a flexo printing method, an offset printing method, an inkjet coating method, a dispenser printing method, a nozzle coating method, and a capillary coating method, and a slit coating method, a capillary coating method, a gravure coating method, a microgravure coating method, a bar coating method, a knife coating method, a nozzle coating method, an inkjet coating method or a spin coating method is preferred.

The organic thin films included in the organic layer can exhibit high carrier (electron or hole) transportability and are therefore capable of transporting electrons and holes injected from electrodes provided on these organic thin films, or charges generated by light absorption, and the organic thin films can be applied to various devices such as photoelectric conversion devices of an organic thin film transistor, an organic solar battery, an optical sensor and the like, making use of these characteristics. These devices will be individually described below.

When the composition of the present invention is used in the photoelectric conversion device, it is preferred to contain an electron-donating compound and/or an electron-accepting compound in an active layer so as to enhance characteristics of the active layer. The first compound may be an electron-donating compound or an electron-accepting compound, and a compound other then the first compound can also be used by being mixed as the electron-donating compound or the electron-accepting compound.

The electron-donating compound and the electron-accepting compound can be relatively determined by energy level of energy levels of these compounds.

### <Device>

The device of the present invention comprises a first electrode and a second electrode, and an active layer between the first electrode and the second electrode, the active layer containing the composition of the present invention.

Examples of the device of the present invention include a photoelectric conversion device, an organic thin film transistor (device) and an organic electroluminescence device.

The device of the present invention can be produced by a method for producing a device comprising a first electrode and a second electrode, and an active layer between the first electrode and the second electrode, the method comprising a step of applying the composition ink of the present invention on the first electrode by an applying method to form an active layer, and a step of forming the second electrode on the active layer.

### <Photoelectric Conversion Device>

The photoelectric conversion device of the present invention comprises one or more active layers containing the composition of the present invention between a pair of electrodes, at least one of which is transparent or translucent.

In a preferred mode of the photoelectric conversion device of the present invention, the photoelectric conversion device comprises a pair of electrodes, at least one of which is transparent or translucent, and an active layer formed from an organic composition of a p-type organic semiconductor and an n-type organic semiconductor. It is preferred that the first compound is a p-type organic semiconductor and the second compound is an n-type organic semiconductor. A motion mechanism of the photoelectric conversion device of this mode will be described. Energy of light incident from the transparent or translucent electrode is absorbed by the electron-accepting compound (n-type organic semiconductor) such as a fullerene derivative and/or the electron-donating compound (p-type organic semiconductor) such as a conjugated polymer compound to form excitons in which electrons and holes combine. When the excitons thus formed move and reach a heterojunction interface where the electron-accepting compound is adjacent to the electron-donating compound, electrons and holes are separated due to a difference in the respective HOMO energy and LUMO energy at the interface to generate charges (electrons and holes) capable of independently moving. The charges thus generated can be extracted outside as electric energy (current) by respectively moving to the electrode.

The photoelectric conversion device of the present invention is usually formed on a substrate. This substrate may be any substrate as long as it forms the electrode and does not change when a layer of an organic substance is formed. Examples of the material of the substrate include glass, plastic, polymer film, and silicon. In a case of an opaque substrate, the opposite electrode (i.e., an electrode which is far from the substrate) is preferably transparent or translucent.

Examples of the transparent or translucent electrode material include a conductive metal oxide film and a translucent metal thin film. Specifically, a film (NESA, etc.) formed of conductivity materials composed of indium oxide, zinc oxide, tin oxide, and a complex thereof such as indium tin oxide (ITO) or indium zinc oxide, gold, platinum, silver, copper, and the like are used, and ITO, indium zinc oxide and tin oxide are preferred. Examples of the method of producing an electrode include a vacuum deposition method, a sputtering method, an ion plating method, and a plating method. As the electrode material, an organic transparent conductive film formed of polyaniline and a derivative thereof, polythiophene and a derivative thereof, and the like may be used. Furthermore, metal, a conductive polymer, and the like can be used as the electrode material. Preferably, one electrode of a pair of electrodes is formed of a material having a small work function. For example, it is possible to use metals such as lithium, sodium, potassium, rubidium, cesium, magnesium, calcium, strontium, barium, aluminum, scandium, vanadium, zinc, yttrium, indium, cerium, samarium, europium, terbium, and ytterbium, and an alloy of two or more metals, or an alloy of one or more of metals and one or more of gold, silver, platinum, copper, manganese, titanium, cobalt, nickel, tungsten and titanium, and graphite or a graphite intercalation compound.

Examples of the alloy include a magnesium-silver alloy, a magnesium-indium alloy, a magnesium-aluminum alloy, an indium-silver alloy, a lithium-aluminum alloy, a lithium-magnesium alloy, a lithium-indium alloy, and a calcium-aluminum alloy.

As means adapted to improve photoelectric conversion efficiency, an additional intermediate layer other than the active layer may be used. Examples of the material used as an intermediate layer include alkali metals such as lithium fluoride, halides of alkali earth metal, oxides such as titanium oxide, and PEDOT (poly-3,4-ethylenedioxythiophene). Oxides such as titanium oxide may be used in the form of fine particles.

An organic thin film solar battery as an aspect of the photoelectric conversion device can have a module structure which is basically the same as that of a conventional solar battery module. The solar battery module commonly has a structure in which a cell is formed on a supporting substrate of metal, ceramic or the like and a filling resin, a protective glass or the like is covered thereon, and light is captured from the opposite side of the supporting substrate. It is also possible to have a structure in which a transparent material such as reinforced glass is used as the material of a supporting substrate and a cell is formed thereon, and light is captured from the side of a transparent supporting substrate. Specifically, a module structure referred to as a super straight type, a substrate type or a potting type, a substrate integrated type module structure used in an amorphous silicone solar battery or the like, and the like are known. Also, in the organic thin film solar battery of the present invention, these module structures can be appropriately selected according to purposes of use, places of use and environment.

A typical super straight type or substrate type module has a structure in which cells are arranged at a given interval between supporting substrates whose one side or both sides is/are transparent and subjected to an antireflection treatment, and adjacent cells are connected to each other by a metal lead or flexible wiring, and also a current collecting electrode is arranged at an external peripheral portion and electric power generated is extracted outside. Between the substrate and cells, various plastic materials such as ethylene vinyl acetate (EVA) may be used in the form of a film or a filling resin according to the purposes for protecting cells and improving current collecting efficiency. When used in the place where the covering of the surface with a hard material is not required, for example, a place where exposed to little impact from the outside, a surface protective layer is formed of a transparent plastic film or a protective function is imparted by curing the filling resin, and thus a supporting substrate of one side can be omitted. The periphery of the supporting substrate is fixed with a frame made of metal in a sandwich shape so as to ensure seal inside and rigidity of a module, and the space between the supporting substrate and the frame is sealed with a sealing material. A solar battery can also be formed on a curved surface when a flexible material is used as the cell per se, or a supporting substrate, a filling material and a sealing material.

In a case of a solar battery using a flexible substrate such as a polymer film, a battery body can be produced by sequentially forming cells while feeding a roll-shaped substrate, cutting into a desired size and then sealing a peripheral portion with a flexible and moisture-resistant material. It is also possible to employ a module structure called "SCAF" described in Solar Energy Materials and Solar Cells, 48, p383-391. Furthermore, a solar battery using a flexible substrate can also be used in a state of being bonded and fixed to a curved glass or the like.

### <Organic Thin Film Transistor>

When the device of the present invention is an organic thin film transistor, the organic thin film transistor includes, for example, an organic thin film transistor with a constitution including a source electrode and a drain electrode, an organic semiconductor layer (active layer) serving as a current path formed between these electrodes, and a gate electrode for controlling the amount of a current which passes through this current path, and the organic semiconductor layer is formed of the above organic thin film. Examples of such an organic thin film transistor include a field effect type organic thin film transistor and a static induction type organic thin film transistor.

It is preferred that the field effect type organic thin film transistor is provided with a source electrode and a drain electrode, an organic semiconductor layer (active layer) serving as a current path formed between these electrodes, a gate electrode for controlling the amount of a current which passes through this current path, and an insulating layer arranged between the organic semiconductor layer and the gate electrode.

It is particularly preferred that the source electrode and drain electrode are arranged in contact with the organic semiconductor layer (active layer) and also the gate electrode is arranged to sandwich the insulating layer in contact with the organic semiconductor layer. In the field effect type organic thin film transistor, the organic semiconductor layer is formed of an organic thin film made of the composition of the present invention.

It is preferred that the static induction type organic thin film transistor includes a source electrode and a drain electrode, an organic semiconductor layer (active layer) serving as a current path formed between these electrodes, a gate electrode for controlling the amount of a current which passes through this current path, and this gate electrode is provided in the organic semiconductor layer. It is particularly preferred that the source electrode, the drain electrode, and the gate electrode provided in the organic semiconductor layer are provided in contact with the organic semiconductor layer. Herein, the structure of the gate electrode may be a structure in which a path of a current flowing from the source electrode to the drain electrode is formed and also the amount of a current flowing through the current path can be controlled by a voltage applied to the gate electrode. For example, it is exemplified by a comb-shaped electrode. Also in the static induction type organic thin film transistor, the organic semiconductor layer is formed of an organic thin film made of the composition of the present invention.

The above organic thin film transistor can be used, for example, as a pixel driving device or the like which is used to control uniformity of screen luminance and a screen rewriting speed of an electrophoretic display, a liquid crystal display, an organic electroluminescence display and the like.

The device of the present invention can be operated as an organic optical sensor when a photocurrent flows by irradiation with light from transparent or translucent electrodes in a state where a voltage is applied or not between the electrodes. The device can also be used as an organic image sensor by integrating a plurality of organic optical sensors.

### <Organic Electroluminescence Device>

The composition of the present invention can also be used in an organic electroluminescence device (an organic EL device). It is preferred that the organic EL device includes an emissive layer between a pair of electrodes, at least one of which is transparent or translucent, and the composition of the present invention is contained in the emissive layer. In the emissive layer, in addition to the composition of the present invention, a charge transporting material (which means a generic term of an electron transporting material and a positive hole transporting material) may be contained. Examples of the organic EL device include a device comprising an anode, an emissive layer and a cathode; a device comprising an anode, an emissive layer, an electron transporting layer and a cathode, the electron transporting layer containing an electron transporting material being formed between the cathode and the emissive layer adjacent to the emissive layer; a device comprising an anode, a hole transporting layer, an emissive layer and a cathode, the positive hole transporting layer containing a positive hole transporting material being formed between the anode and the emissive layer adjacent to the emissive layer; and a device comprising an anode, a positive hole transporting layer, an emissive layer, an electron transporting layer and a cathode. The composition of the present invention can also be used in a positive hole transporting layer and an electron transporting layer.

### EXAMPLES

Examples will be illustrated so as to describe the present invention in more detail, but the present invention is not limited thereto.

### (Reference Example 1)

### Production of 2-bromo-3-dodecylthiophene

Under an argon atmosphere, 15.0 g (59.4 mmol) of 3-dodecylthiophene (manufactured by Aldrich Corporation) and 50 ml of dehydrated N,N-dimethylformamide (hereinafter sometimes referred to as DMF) were charged in a 200 ml three-necked flask to obtain a uniform solution. While maintaining the flask at 0°C, a DMF (100 ml) solution of 10.6 g (59.3 mmol) of N-bromosuccinimide (hereinafter sometimes referred to as NBS) was added dropwise over one hour. After dropwise addition, while maintaining the flask at 0°C, stirring was performed for 6 hours. Thereafter, the reaction solution was poured into 400 ml of water, and the solution was extracted five times with 50 ml of diethyl ether. The oil layer was washed three times with water and dried over magnesium sulfate, and then the solvent was distilled off under reduced pressure to obtain 17.8 g of 2-bromo-3-dodecylthiophene as the objective product. 1H NMR: δ 7.18 (d, 1H), 6.79 (d, 1H), 2.57 (t, 2H), 1.57-1.29 (m, 20H), 0.88 (t, 3H).

### (Reference Example 2)

### Production of 3-dodecylthiophene-2-carbaldehyde

Under an argon atmosphere, 2.40 g (98.7 mmol) of metallic magnesium was charged in a 500 ml three-necked flask and magnesium was activated for one hour by heating at 150°C while stirring using a stirrer chip. After cooling to room temperature, dehydrated tetrahydrofuran (THF) (96 ml) was charged and 50 mg of iodine was added, and also a solution prepared by dissolving 24.0 g (72.4 mmol) of 2-bromo-3-dodecylthiophene synthesized in Reference Example 1 in 96 ml of THF was added dropwise at room temperature over 30 minutes. After the dropwise addition, the mixture was refluxed for 30 minutes and then cooled to room temperature, and 10.5 g (144 mmol) of DMF was added dropwise over 15 minutes. After stirring at room temperature for 2 hours, hydrochloric acid was added to the reaction system until the pH reached about 2, followed by extraction five times with ethyl acetate. The oil layer was washed with water, saturated brine and water and dried over magnesium sulfate, and then the solvent was distilled off by an evaporator to obtain 20.4 g of a crude product. This crude product was purified by a silica gel column (hexane/ethyl acetate = 10/1 (volume ratio)) to obtain 18.2 g (64.9 mmol, yield: 89.6%) of 3-dodecylthiophene-2-carbaldehyde as the objective product. 1H NMR: δ = 10.0(s, 1H), 7.64(d, 1H), 7.01(d, 1H), 2.96(t, 2H), 1.69-1.26(m, 20H), 0.88(t, 3H).

### (Reference Example 3)

### Production of 2,5-bis(3-dodecylthiophen-2-yl)thiazolo[5,4-d]thiazole

In a 100 ml flask, 18.0 g (64.0 mmol) of 3-dodecylthiophene-2-carbaldehyde synthesized in Reference Example 2 and 2.56 g of rubeanic acid (manufactured by Tokyo Chemical Industry Co., Ltd.) were charged and then heated at 200°C for 6 hours. After the reaction, the reaction solution was cooled to room temperature, diluted with a solvent of hexane/ethyl acetate = 10/1 (volume ratio) and then filtered with celite. The filtrate was concentrated and purified by a silica gel column (toluene/hexane = 5/5 (volume ratio) to obtain 5.2 g (8.08 mmol) of 2,5-bis(3-dodecylthiophen-2-yl)thiazolo[5,4-d]thiazole as the objective product. 1H NMR: δ = 7.35(d, 2H), 6.99(d, 2H), 2.97(t, 4H), 1.72-1.26(m, 40H), 0.88(t, 6H).

### (Reference Example 4)

### Production of 2,5-bis(5-bromo-3-dodecylthiophen-2-yl)thiazolo[5,4-d]thiazole

Under an argon atmosphere, 3.28 g (5.10 mmol) of 2,5-bis(3-dadecylthiophen-2-yl)thiazolo[5,4-d]thiazole synthesized above and 140 ml of dry DMF were charged in a 100 ml three-necked flask and then dissolved with stirring at 50°C. To this solution, a dry DMF (50 ml) solution of 1.91 g (5.10 mmol) of NBS was added dropwise at 50°C over 30 minutes, followed by stirring at 50°C for 4 hours. After the reaction, the solution was cooled to room temperature, extracted five times with chloroform and dried over magnesium sulfate, and then the solvent was distilled off by an evaporator to obtain a crude product. This crude product was purified by a silica gel column (hexane/toluene = 7/3 (volume ratio)) to obtain 3.80 g (4.74 mmol) of 2,5-bis(5-bromo-3-dodecylthiophen-2-yl)thiazolo[5,4-d]thiazole as the objective product. 1H NMR: δ = 6.93(s, 2H), 2.86(t, 4H), 1.68-1.26(m, 40H), 0.88(t, 6H).

### Reference Example 5

### (Production of Polymer A)

Using 2,5-bis(5-bromo-3-dodecylthiophen-2-yl)thiazolo[5,4-d]thiazole (monomer A) produced in aforementioned Reference Example 4, 2,1,3-benzothiadiazole-4,7-bis(boronic acid pinacol ester) (monomer B) (manufactured by Aldrich Corporation) and 9,9-dioctylfluorene-2,7-diboronic acid (monomer C) (manufactured by American Dye Source, Inc.), a polymer A was produced in the following manner.

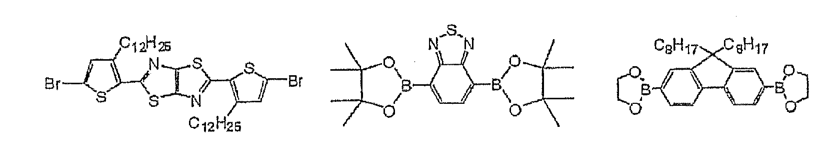

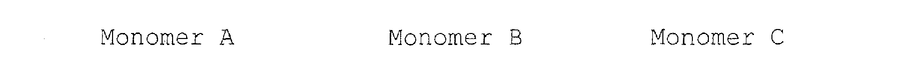

Under an argon atmosphere, 200 mg (0.250 mmol) of a monomer A, 48.5 mg (0.125 mmol) of a monomer B, 66.2 mg (0.125 mmol) of a monomer C, 108 mg of methyltrialkylammonium chloride (manufactured by Aldrich Corporation under the trade name of Aliquat336 (registered trademark)) and 11 mL of toluene were charged in a reaction vessel and the atmosphere inside the reaction vessel was sufficiently deaerated by bubbling using argon. Furthermore, 1.20 mg (0.00534 mmol) of palladium acetate, 6.10 mg (0.0173 mmol) of tris(methoxyphenyl)phosphine and 2.4 mL of the deaerated aqueous sodium carbonate solution (16.7% by weight) were added and the mixture was refluxed for 5 hours. Next, 60.0 mg of phenylboric acid was added to the obtained reaction solution, followed by refluxing for 2 hours. Furthermore, 10 ml of an aqueous sodium diethyldithiocarbamate solution (9.1% by weight) was added, followed by refluxing for 2 hours.

After the completion of the reaction, the reaction solution was cooled to around room temperature (25°C) and then the obtained reaction solution was left to stand and the separated toluene layer was recovered. The toluene layer was washed twice with 10 mL of water, washed twice with 3% acetic acid aqueous solution, washed twice with 10 mL of water and then washed twice with 10 mL of water. The obtained toluene layer was poured into methanol and then the precipitate was recovered. This precipitate was dried under reduced pressure and then dissolved in chloroform. Next, the obtained chloroform solution was filtered and insolubles were removed, and then the solution was purified by passing through an alumina column. The obtained chloroform solution was concentrated under reduced pressure and poured into methanol, and then the precipitate thus obtained was recovered. This precipitate was washed with methanol and then dried under reduced pressure to obtain 101 mg of a polymer. Hereinafter, this polymer is referred to as a polymer A. The polymer A had a polystyrene-equivalent weight average molecular weight of 20,700 and a polystyrene-equivalent number average molecular weight of 7,000. The polymer A showed a light absorption end wavelength of 738 nm.

### Reference Example 6

### (Production of Polymer B)

The same operation was performed, except that 200 mg (0.250 mmol) of the monomer A, 63 mg (0.162 mmol) of the monomer B and 46 mg (0.0873 mmol) of the monomer C were used in Example 1, to produce a polymer B. The polymer B had a polystyrene-equivalent weight average molecular weight of 11,000 and a polystyrene-equivalent number average molecular weight of 4,300. The polymer B showed a light absorption end wavelength of 734 nm.

### Reference Example 7

### (Production of Polymer C)

The same operation was performed, except that 200 mg (0.250 mmol) of the monomer A and 48.5 mg (0.125 mmol) of the monomer B were used and 73.9 mg (0.125 mmol) of 9,9-didodecylfluorene-2,7-diboronic acid (monomer D) (manufactured by Aldrich Corporation): 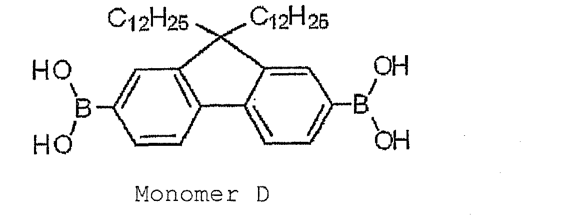 was used in place of the monomer C in Example 1, to produce a polymer C. The polymer C had a polystyrene-equivalent weight average molecular weight of 11,000 and a polystyrene-equivalent number average molecular weight of 4,900. The polymer C showed a light absorption end wavelength of 738 nm.

### Example 1

### (Production and Evaluation of Composition and Organic Thin Film Solar Battery)

A glass substrate with a 150 nm thick ITO film formed by a sputter method was subjected to a surface treatment by an ozone UV treatment. Next, a polymer A as a first compound and a fullerene C60PCBM (phenyl C61-butyric acid methyl ester, manufactured by Frontier Carbon Corporation) (a weight ratio: polymer A/C60PCBM = 1/3) as a second compound were dissolved in orthodichlorobenzene (the total of the weight of the polymer A and the weight of C60PCBM was 2.0% by weight) to produce a composition ink 1. The composition ink 1 was applied on the substrate by spin coating (a rotary speed of a spin coater = 1,500 rpm) to form an organic film made of a composition containing the first compound and the second compound (film thickness: about 100 nm). The organic film thus formed showed a light absorption end wavelength of 745 nm. Thereafter, lithium fluoride was deposited on the organic film in a thickness of 2 nm by a vacuum deposition machine, and then Al was deposited thereon in a thickness of 100 nm. The obtained organic thin film solar battery had a shape of square measuring 2 mm × 2 mm. The obtained organic thin film solar battery was irradiated with light having a given irradiance using a solar simulator (manufactured by BUNKOUKEIKI Co., Ltd. under the trade name of OTENTO-SUNII:AM1.5G filter, irradiance: 100 mW/cm²). The current and voltage generated were measured and a photoelectric conversion efficiency, a short-circuit current density, an open circuit voltage and a fill factor were determined. Jsc (short-circuit current density) was 5.12 mA/cm², Voc (open circuit voltage) was 0.85 V, ff (fill factor) was 0.57, and photoelectric conversion efficiency (η) was 2.48%.

### Example 2

### (Production and Evaluation of Composition and Organic Thin Film Solar Battery)

In the same manner as in Example 1, except that a weight ratio of mixing a polymer A with C60PCBM was set at 1/1, a composition ink and an organic thin film solar battery were produced, and then a photoelectric conversion efficiency, a short-circuit current density, an open circuit voltage and a fill factor were determined. The results are shown in Table 1.

### Example 3

### (Production and Evaluation of Composition and Organic Thin Film Solar Battery)

In the same manner as in Example 1, except that a weight ratio of mixing a polymer A with C60PCBM was set at 1/2, a composition ink and an organic thin film solar battery were produced, and then a photoelectric conversion efficiency, a short-circuit current density, an open circuit voltage and a fill factor were determined. The results are shown in Table 1.

### Example 4

### (Production and Evaluation of Composition and Organic Thin Film Solar Battery)

In the same manner as in Example 1, except that a weight ratio of mixing a polymer A with C60PCBM was set at 1/4, a composition ink and an organic thin film solar battery were produced, and then a photoelectric conversion efficiency, a short-circuit current density, an open circuit voltage and a fill factor were determined. The results are shown in Table 1.

### Example 5

### (Production and Evaluation of Composition and Organic Thin Film Solar Battery)

In the same manner as in Example 1, except that a weight ratio of mixing a polymer A with C60PCBM was set at 1/5, a composition ink and an organic thin film solar battery were produced, and then a photoelectric conversion efficiency, a short-circuit current density, an open circuit voltage and a fill factor were determined. The results are shown in Table 1.

**Table 1: Photoelectric Conversion Device Evaluation Results**

| | Example 2 | Example 3 | Example 4 | Example 5 |
|---|---|---|---|---|
| Short-circuit current density (mA/cm²) | 4.84 | 5.51 | 4.70 | 4.30 |
| Open circuit voltage (V) | 0.89 | 0.87 | 0.85 | 0.83 |
| Fill factor | 0.53 | 0.61 | 0.61 | 0.63 |
| Conversion efficiency (%) | 2.31 | 2.93 | 2.44 | 2.25 |

### Example 6

### (Production and Evaluation of Composition and Organic Thin Film Solar Battery)

In the same manner as in Example 2, except that a polymer B was used in place of the polymer A, a composition ink and an organic thin film solar battery were produced, and then a photoelectric conversion efficiency, a short-circuit current density, an open circuit voltage and a fill factor were determined. The results are shown in Table 2.

### Example 7

### (Production and Evaluation of Composition and Organic Thin Film Solar Battery)

In the same manner as in Example 6, except that a weight ratio of mixing a polymer B with C60PCBM was set at 1/3, a composition ink and an organic thin film solar battery were produced, and then a photoelectric conversion efficiency, a short-circuit current density, an open circuit voltage and a fill factor were determined. The results are shown in Table 2.

### Example 8

### (Production and Evaluation of Composition and Organic Thin Film Solar Battery)

In the same manner as in Example 6, except that a weight ratio of mixing a polymer B with C60PCBM was set at 1/5, a composition ink and an organic thin film solar battery were produced, and then a photoelectric conversion efficiency, a snort-circuit current density, an open circuit voltage and a fill factor were determined. The results are shown in Table 2.

**Table 2: Photoelectric Conversion Device Evaluation Results**

| | Example 6 | Example 7 | Example 8 |
|---|---|---|---|
| Short-circuit current density (mA/cm²) | 4.49 | 4.56 | 4.31 |
| Open circuit voltage (V) | 0.86 | 0.84 | 0.81 |
| Fill factor | 0.58 | 0.59 | 0.62 |
| Conversion efficiency (%) | 2.23 | 2.24 | 2.17 |

### Example 9

### (Production and Evaluation of Organic Thin Film Solar Battery)

In the same manner as in Example 2, except that a polymer C was used in place of the polymer A, a composition ink and an organic thin film solar battery were produced, and then a photoelectric conversion efficiency, a short-circuit current density, an open circuit voltage and a fill factor were determined. The results are shown in Table 3.

**Table 3: Photoelectric Conversion Device Evaluation Results**

| | Example 9 |
|---|---|
| Short-circuit current density (mA/cm²) | 2.63 |
| Open circuit voltage (V) | 0.97 |
| Fill factor | 0.51 |
| Conversion efficiency (%) | 1.29 |

### Example 10

### (Production and Evaluation of Composition and Organic Thin Film Solar Battery)

In the same manner as in Example 3, except that C70PCBM (phenyl C71-butyric acid methyl ester, manufactured by Frontier Carbon Corporation) was used in place of C60PCBM, a composition ink and an organic thin film solar battery were produced, and then a photoelectric conversion efficiency, a short-circuit current density, an open circuit voltage and a fill factor were determined. The results are shown in Table 4.

**Table 4: Photoelectric Conversion Device Evaluation Results**

| | Example 10 |
|---|---|
| Short-circuit current density (mA/cm²) | 7.29 |
| Open circuit voltage (V) | 0.85 |
| Fill factor | 0.58 |
| Conversion efficiency (%) | 3.57 |

### Reference Example 8

### (Production of Polymer D)

The same operation was performed, except that 200 mg (0.250 mmol) of the monomer A and 119 mg (0.225 mmol) of the monomer C were used and the monomer B was not used in Reference Example 5, to produce a polymer D. The polymer D had a polystyrene-equivalent weight average molecular weight of 47,000 and a polystyrene-equivalent number average molecular weight of 12,000. The polymer D showed a light absorption end wavelength of 573 nm.

### Example 11

### (Evaluation of Photoelectric Conversion Device of Polymer D)

In the same manner, except that a polymer D was used in place of the polymer A in Example 1, a composition ink and an organic thin film solar battery were produced, and then a photoelectric conversion efficiency, a short-circuit current density, an open circuit voltage and a fill factor were determined. The results are shown in Table 5.

**Table 5: Photoelectric Conversion Device Evaluation Results**

| | Example 11 |
|---|---|
| Short-circuit current density (mA/cm²) | 2.12 |
| Open circuit voltage (V) | 1.00 |
| Fill factor | 0.56 |
| Conversion efficiency (%) | 1.19 |

### Reference Example 9

### (Synthesis of Polymer E)

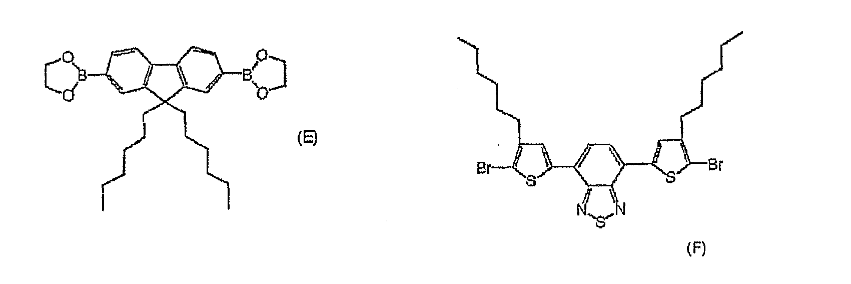

A compound E (0.949 g), 1.253 g of a compound F, 0.30 g of methyltrialkylammonium chloride (manufactured by Aldrich Corporation under the trade name of Aliquat336 (registered trademark)) and 3.4 mg of dichlorobis(triphenylphosphine)palladium(II) were charged in a reaction vessel and the atmosphere inside the reaction vessel was replaced by an argon gas. Toluene (45ml) deaerated in advance by bubbling an argon gas was added to this reaction vessel. Next, to this solution, 10 ml of an aqueous 16.7% by weight sodium carbonate solution deaerated in advance by bubbling an argon gas was added dropwise under stirring, followed by refluxing for 12 hours. Next, the reaction solution was cooled and a mixed phenylboric acid (0.1 g)/tetrahydrofuran (0.5 ml) solution was added, followed by refluxing for 2 hours. The reaction was performed under an argon gas atmosphere. After completion of the reaction, the reaction solution was cooled and 60 g of toluene was added to this reaction solution. This reaction solution was left to stand and subjected to liquid separation, and then a toluene solution was recovered. Next, this toluene solution was filtered to remove insolubles. Next, this toluene solution was purified by passing through an alumina column. Next, this toluene solution was poured into methanol and purified by reprecipitation, and the precipitate thus obtained was recovered. Next, this precipitate was dried under reduced pressure and then dissolved again in toluene. Next, this toluene solution was filtered and then this toluene solution was purified by passing through an alumina column. Next, this toluene solution was poured into methanol and purified by reprecipitation, and the precipitate thus obtained was recovered. This precipitate was washed with methanol and then dried under reduced pressure to obtain 0.5 g of a polymer E. The polymer E had a polystyrene-equivalent weight average molecular weight of 9.9 × 10⁴ and a polystyrene-equivalent number average molecular weight of 6.1 × 10⁴. A repeating unit contained in the polymer E, estimated from charging, is as follows.

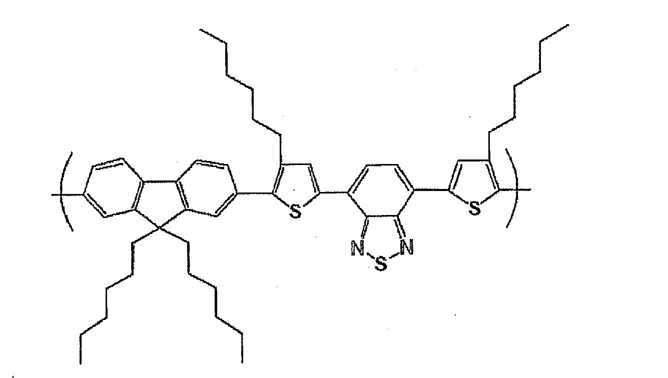

### Comparative Example 1

### (Evaluation of Photoelectric Conversion Device of Polymer E)

The polymer E was dissolved in xylene in the concentration of 0.75% (% by weight). Then, C60PCBM was mixed with the solution in the weight which was three times larger than that of the polymer E. Then, the mixture was filtered with a 1.0 µm Teflon (registered trademark) filter to prepare an applying solution.

A glass substrate with a 150 nm thick ITO film formed by a sputter method was subjected to a surface treatment by an ozone UV treatment. Next, the applying solution was applied on the substrate by spin coating to form an organic film made of a composition containing the polymer E and C60PCBM (film thickness: about 80 nm). Thereafter, lithium fluoride was deposited on the organic film in a thickness of 4 nm by a vacuum deposition machine, and then Al was deposited thereon in a thickness of 100 nm. The obtained organic thin film solar battery had a shape of square measuring 2 mm × 2 mm. The obtained organic thin film solar battery was irradiated with light having a given irradiance using a solar simulator (manufactured by BUNKOUKEIKI Co., Ltd. under the trade name of OTENTO-SUNII:AM1.5G filter, irradiance: 100 mW/cm²). The current and voltage generated were measured and a photoelectric conversion efficiency was determined. The measurement results are shown in Table 6.

**Table 6: Photoelectric Conversion Device Evaluation Results**

| | Conversion efficiency (%) |
|---|---|
| Comparative Example 1 | 0.9 |

### Example 12

### (Evaluation of Photoelectric Conversion Device of Polymer A)

In the same manner, except that chlorobenzene was used in place of orthodichlorobenzene in Example 1, a composition ink and an organic thin film solar battery were produced, and then a photoelectric conversion efficiency, a short-circuit current density, an open circuit voltage and a fill factor were determined. The measurement results are shown in Table 7.

### Example 13

### (Evaluation of Photoelectric Conversion Device of Polymer A)

In the same manner, except that 1,2,4-trichlorobenzene was used in place of orthodichlorobenzene in Example 1, a composition ink and an organic thin film solar battery were produced, and then a photoelectric conversion efficiency, a short-circuit current density, an open circuit voltage and a fill factor were determined. The measurement results are shown in Table 7.

### Example 14

### (Evaluation of Photoelectric Conversion Device of Polymer A)

In the same manner, except that the rotary speed of the spin coater was set at 800 rpm and the film thickness of the organic film was set at 152 nm in Example 1, a composition ink and an organic thin film solar battery were produced, and then a photoelectric conversion efficiency, a short-circuit current density, an open circuit voltage and a fill factor were determined. The measurement results are shown in Table 7.

### Example 15

### (Evaluation of Photoelectric Conversion Device of Polymer A)

In the same manner, except that the rotary speed of the spin coater was set at 650 rpm and the film thickness of the organic film was set at 198 nm in Example 1, a composition ink and an organic thin film solar battery were produced, and then a photoelectric conversion efficiency, a short-circuit current density, an open circuit voltage and a fill factor were determined. The measurement results are shown in Table 7.

### Example 16

### (Evaluation of Photoelectric Conversion Device of Polymer A)

In the same manner, except that the rotary speed of the spin coater was set at 450 rpm and the film thickness of the organic film was set at 253 nm in Example 1, a composition ink and an organic thin film solar battery were produced, and then a photoelectric conversion efficiency, a short-circuit current density, an open circuit voltage and a fill factor were determined. The measurement results are shown in Table 7.

**Table 7: Photoelectric Conversion Device Evaluation Results**

| | Example 12 | Example 13 | Example 74 | Example 15 | Example 16 |
|---|---|---|---|---|---|
| Short-circuit current density (mA/cm²) | 5.24 | 5.31 | 5.87 | 6.60 | 7.12 |
| Open circuit voltage (V) | 0.85 | 0.85 | 0.84 | 0.85 | 0.85 |
| Fill factor | 0.58 | 0.52 | 0.47 | 0.41 | 0.42 |
| Conversion efficiency (%) | 2.58 | 2.35 | 2.32 | 2.30 | 2.54 |

### Example 17

### (Evaluation of Photoelectric Conversion Device of Polymer A)

In the same manner, except that the rotary speed of the spin coater was set at 850 rpm and the film thickness of the organic film was set at 151 nm in Example 10, a composition ink and an organic thin film solar battery were produced, and then a photoelectric conversion efficiency, a short-circuit current density, an open circuit voltage and a fill factor were determined. The measurement results are shown in Table 8.

### Example 18

### (Evaluation of Photoelectric Conversion Device of Polymer A)

In the same manner, except that the rotary speed of the spin coater was set at 700 rpm and the film thickness of the organic film was set at 205 nm in Example 10, a composition ink and an organic thin film solar battery were produced, and then a photoelectric conversion efficiency, a short-circuit current density, an open circuit voltage and a fill factor were determined. The measurement results are shown in Table 8.

### Example 19

### (Evaluation of Photoelectric Conversion Device of Polymer A)

In the same manner, except that the rotary speed of the spin coater was set at 500 rpm and the film thickness of the organic film was set at 249 nm in Example 10, a composition ink and an organic thin film solar battery were produced, and then a photoelectric conversion efficiency, a short-circuit current density, an open circuit voltage and a fill factor were determined. The measurement results are shown in Table 8.

**Table 8: Photoelectric Conversion Device Evaluation Results**

| | Example 17 | Example 18 | Example 19 |
|---|---|---|---|
| Short-circuit current density (mA/cm²) | 6.56 | 7.61 | 8.09 |
| Open circuit voltage (V) | 0.84 | 0.84 | 0.84 |
| Fill factor | 0.52 | 0.46 | 0.43 |
| Conversion efficiency (%) | 2.87 | 2.94 | 2.92 |

### INDUSTRIAL APPLICABILITY

The photoelectric conversion device produced using the composition of the present invention exhibits high conversion efficiency and is therefore industrially very useful.

## Claims

1. A composition comprising a first compound having a structure represented by formula (1), and a second compound composed of only a structure different from the structure represented by formula (1).

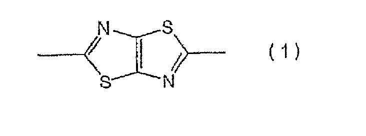

2. The composition according to claim 1, wherein the first compound further includes a structure different from the structure represented by formula (1).

3. The composition according to claim 2, wherein the structure different from the structure represented by formula (1) is a structure represented by any one of formulas (2) to (7): 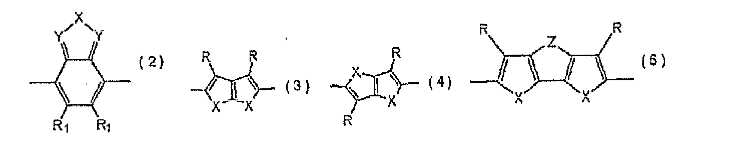 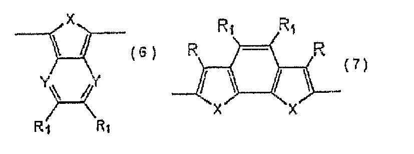 in formulas (2) to (7), X's are the same or different and represent a sulfur atom, an oxygen atom, a selenium atom, - N(R₁₀)- or -CR₁₁=CR₁₂- and, when a plurality of X's are present, they may be the same or different; R₁₀, R₁₁ and R₁₂ are the same or different and represent a hydrogen atom or a substituent; R and R₁ are the same or different and represent a hydrogen atom or a substituent, and a plurality of R's and R₁'s may be the same or different and two R₁'s may combine with each other to form a cyclic structure; Y represents a nitrogen atom or =CH- and, when a plurality of Y's are present, they may be the same or different; Z represents a sulfur atom, an oxygen atom, a selenium atom, -N(R₂₀)-, -Si(R₂₁R₂₂)- or -C(R₂₃R₂₄)-; R₂₀ to R₂₄ are the same or different and represent a hydrogen atom or a substituent; R₂₁ and R₂₂ may combine to form a cyclic structure; and R₂₃ and R₂₄ may combine to form a cyclic structure.

4. The composition according to any one of claims 1 to 3, wherein the first compound is a polymer compound.

5. The composition according to claim 4, wherein the first compound has a weight average molecular weight of 10,000 or more.

6. The composition according to any one of claims 1 to 5, wherein the second compound is an electron-accepting compound or an electron-donating compound.

7. The composition according to claim 6, wherein the second compound is an electron-accepting compound having a work function of 3.0 eV or more.

8. The composition according to claim 6 or 7, wherein the electron-accepting compound includes fullerenes or derivatives of fullerenes.

9. A composition ink comprising the composition according to any one of claims 1 to 8 and a solvent.

10. The composition ink according to claim 9, wherein the solvent is one or more compounds selected from the group consisting of an aromatic compound having a substituent, a linear alkane, a branched alkane, a cycloalkane, a linear alcohol, a branched alcohol and an alicyclic alcohol.

11. The composition ink according to claim 9 or 10, wherein the solvent has a surface tension of 15 mN/m to 100 mN/m.

12. A device comprising a first electrode and a second electrode, and an active layer between the first electrode and the second electrode, the active layer containing the composition according to any one of claims 1 to 8.

13. A solar battery module comprising the device according to claim 12.

14. An image sensor comprising the device according to claim 12.

15. A method for producing a device comprising a first electrode and a second electrode, and an active layer between the first electrode and the second electrode, the method comprising the steps of applying the composition ink according to any one of claims 9 to 11 on the first electrode by an applying method to form the active layer, and forming the second electrode on the active layer.

16. The method for producing a device according to claim 15, wherein the applying method is a slit coating method, a capillary coating method, a gravure coating method, a microgravure coating method, a bar coating method, a knife coating method, a nozzle coating method, an inkjet coating method or a spin coating method.
